# EUROPÄISCHE PATENTSCHRIFT

(11) **EP 3 363 045 B1**
(45) Veröffentlichungstag und Bekanntmachung des Hinweises auf die Patenterteilung: **08.01.2020**
(21) Anmeldenummer: 16775131.2
(22) Anmeldetag: 22.09.2016
(51) Int. Cl.: H05K 13/02, G01N 21/88, H01L 21/683, H01L 21/68, H01L 21/677, H01L 21/67, H01L 23/00, H05K 13/08

(54) **VORRICHTUNG UND VERFAHREN ZUM SELBSTJUSTIEREN EINER BAUTEILHANDHABUNGSVORRICHTUNG FÜR ELEKTRONISCHE BAUTEILE**
DEVICE AND METHOD FOR SELF-ADJUSTMENT OF A COMPONENT HANDLING DEVICE FOR ELECTRONIC COMPONENTS
DISPOSITIF ET MÉTHODE POUR UN AUTO-AJUSTEMENT D'UN APPAREIL DE MANIPULATION DE COMPOSANTS POUR COMPOSANTS ÉLECTRONIQUES

(30) Priorität: 16.10.2015 DE 102015013495
(43) Veröffentlichungstag der Anmeldung: 22.08.2018
(73) Patentinhaber: Mühlbauer GmbH & Co. KG, 93426 Roding (DE)
(72) Erfinder: KOCH, Konstantin, 93426 Roding (DE); FERSTL, Markus, 93413 Cham (DE); BRANDL, Franz, 93455 Sattelpeilnstein Gemeide Traitsching (DE); MIEHLICH, Rainer, 82024 Taufkirchen (DE); LAKHADANAU, Siarhei, 93426 Roding (DE)
(74) Vertreter: Schmidt, Steffen J.
(86) Internationale Anmeldenummer: PCT/EP2016/072482
(87) Internationale Veröffentlichungsnummer: WO 2017/063838

(56) Entgegenhaltungen:
- EP-A1- 1 802 192
- EP-A1- 1 806 043
- EP-A2- 0 906 011
- WO-A1-02/054480
- WO-A1-03/058708
- CN-A- 103 489 811
- DE-A1-102010 053 912
- DE-A1-102013 102 046
- JP-A- 11 295 236
- US-A- 5 249 356
- US-A1- 2004 163 243

## Beschreibung

### Hintergrund

Hier werden eine Vorrichtung und ein Verfahren zum Selbstjustieren einer Bauteilhandhabungsvorrichtung für elektronische Bauteile beschrieben.

Diese Vorrichtung und dieses Verfahren werden im Zusammenwirken mit einer Bauteilhandhabungsvorrichtung, einer Empfangseinrichtung sowie einem bildgebenden Sensor erläutert.

Ein Bauteil ist hier zum Beispiel ein (elektronisches) Halbleiterbauteil, auch als "chip" oder "die" bezeichnet. Ein solches Bauteil hat in der Regel eine prismatische Gestalt, einen im Wesentlichen polygonalen, zum Beispiel viereckigen (rechteckförmigen oder quadratischen) Querschnitt mit mehreren Mantelflächen sowie eine Stirnfläche und eine Deckfläche. Die Mantelflächen sowie die beiden (untere und obere) Deckflächen des Bauteils sind nachfolgend allgemein als Seitenflächen bezeichnet. Das Bauteil kann auch eine von vier abweichende Anzahl von Mantelflächen haben. Ein Bauteil kann auch eine optisches Bauteil (Prisma, Spiegel, Linse, etc.) sein. Insgesamt kann ein Bauteil jede geometrische Form haben.

Aus der betrieblichen Praxis der Anmelderin sind so genannte Aufnehm- und Absetzvorrichtungen bekannt, in denen Bauteile mittels eines Saugers oder Festhalters von einem Bauteiltisch aufgenommen und anschließend auf einem Träger oder in einem Transportbehälter oder dergl. abgelegt werden. Vor dem Ablegen des Bauteils findet üblicherweise eine Inspektion des Bauteils statt. Dazu werden Abbildungen einer oder mehrerer Seitenflächen des Bauteils mit einer oder mehreren Kameras aufgenommen und mittels automatisierter Bildverarbeitung ausgewertet.

### Stand der Technik

Um den in der Halbleiterfertigung geforderten Präzisionsansprüchen gerecht zu werden, ist eine Justierung der Aufnehm- und Absetzvorrichtung der Bauteile vor der Inbetriebnahme, nach dem Auswechseln von Vorrichtungsbestandteilen oder nach Wartungsarbeiten an der Vorrichtung notwendig.

Hierzu müssen die der Aufnehm- und Absetzvorrichtungen der Bauteile vermessen und anschließend justiert werden, um Fertigungs- und Montagetoleranzen zu kompensieren. Dies geschieht durch einen Bediener, welcher die Aufnehm- und Absetzvorrichtung mit Hilfe eines Mikroskops oder eines Kamerabilds zunächst visualisiert um sie anschließend zu vermessen und zu justieren. Das Verfahren ist ausgesprochen zeitintensiv, in der Praxis fehleranfällig und bindet hochqualifiziertes Personal. Je größer die Komplexität einer Vorrichtung, insbesondere je mehr einzelne Vorrichtungsbestandteile je zueinander zu justieren sind, desto größer sind der Zeitaufwand und die Fehleranfälligkeit / Ungenauigkeit der Justierung.

Die Dokumente WO 03/058708-A1, EP 1806043-B1, JP-A-11295236, WO 02/054480-A1 und EP 1802192-A1 offenbaren den Stand der Technik in diesem Fachgebiet.

### Zu lösendes Problem

Eine Bauteilhandhabungsvorrichtung soll das Durchführen einer präzisen Justierung zeiteffizient ermöglichen.

### Hier vorgestellte Lösung

Diese Aufgabe löst eine Bauteilhandhabungsvorrichtung zum Entnehmen von prismatischen Bauteilen von einem strukturierten Bauteilvorrat und zum Ablegen der entnommenen Bauteile an einer Empfangseinrichtung, welche über eine integrierte Selbstjustierungsvorrichtung verfügt. Eine erste Wendeeinrichtung mit mehreren Aufnehmern ist dazu eingerichtet, an einer Spendestelle ein Bauteil von dem strukturierten Bauteilvorrat zu empfangen, das empfangene Bauteil um einen ersten vorbestimmten Winkel um seine Längs- oder Querachse zu wenden Ablagestelle zu fördern. Den ersten und zweiten Wendeeinrichtungen zugeordnete Lage- und Eigenschaftssensoren sind dazu eingerichtet, Lagedaten der ersten und zweiten Wendeeinrichtungen, Lagedaten von an den Aufnehmern befindlichen Bauteilen, und/oder Eigenschaften von an den Aufnehmern befindlichen Bauteilen zu erfassen, und für eine Steuerung zur Verfügung zu stellen.

Die Steuerung ist dazu eingerichtet, durch Lage- und Eigenschaftssensoren, insbesondere vor dem eigentlichen Bauteiltransferbetrieb, im Zuge einer Selbstjustierung für jede Übertragungsstellung, in welcher die erste und/oder die zweite Wendeeinrichtung Bauteile empfangen oder übergeben, jeweils einen Korrekturvektor für die erste und/oder die zweite Wendeeinrichtungen und/oder für die Ablagestelle zu ermitteln, welcher jeweils den im Zuge der Selbstjustierung ermittelten Fertigungs- und Montageungenauigkeiten der Bauteilhandhabungsvorrichtung entgegen gerichtet ist.

Die Steuerung ist weiterhin dazu eingerichtet, mittels eines ersten Drehantriebes die erste Wendeeinrichtung um eine erste Achse kontrolliert zu drehen, mittels eines ersten Linearantriebes die erste Wendeeinrichtung längs der ersten Achse kontrolliert zu verfahren, mittels eines zweiten Drehantriebes die zweite Wendeeinrichtung um eine zu der ersten Achse nicht kollineare zweite Achse kontrolliert zu drehen, und mittels eines zweiten Linearantriebes die zweite Wendeeinrichtung längs der zweiten Achse kontrolliert zu verfahren.

Der durch die Selbstjustierung ermittelte Korrekturvektor dient der Steuerung der Bauteilhandhabungsvorrichtung im Bauteiltransferbetrieb dazu, durch kontrolliertes Verfahren und/oder Drehen der Wendeeinrichtungen und/oder der Ablagestelle, den im Zuge der Selbstjustierung bestimmten Fertigungs- und Montageungenauigkeiten der Bauteilhandhabungsvorrichtung entgegenzuwirken.

So bildet die hier vorgestellte Anordnung eine integrierte Handhabungs-/Inspektionseinrichtung, welche eine automatisierte Selbstjustierung ermöglicht. Bildgebende Sensoren inspizieren alle oder fast alle Deck- und/oder Seitenfläche(n) eines Bauteils und liefern dabei auch relevante Daten zur Positionierung der Manipulatoren (Aufnehmer) und der Empfangsstellen. Diese Einrichtung bildet somit einen Kern eines geschlossenen Maschinensystems mit der notwendigen prozesstechnischen Peripherie, zum Beispiel zur Bereitstellung der Bauteile (zum Beispiel Wafertisch) und Bauteil-Ablage (zum Beispiel Taschen- oder Träger-Band). Die hier vorgestellte Bauteilhandhabungsvorrichtung übernimmt Bauteile von einem zum Beispiel horizontal im oberen Bereich der Bauteilhandhabungsvorrichtung angeordneten Bauteilvorrat (Waferscheibe) mit einer ortsfesten Ausstoßeinheit. Relativ zu dieser ortsfesten Ausstoßeinheit bewegt sich der Bauteilvorrat in der Ebene. Die Ausstoßeinheit bewirkt durch eine Nadel oder berührungslos (z.B. durch einen Laserstrahl), dass die Bauteile einzeln von dem Bauteilvorrat freikommen und von einem Aufnehmer aufgenommen werden. Die ausgestoßenen Bauteile werden insgesamt bis zu sechs oder mehr Inspektionsprozessen zugeführt und abschließend in Empfangsstellen (Taschen) des Taschen- oder Trägerbandes gefördert. Die Begriffe Empfangsstelle und (Ablage-)Tasche werden hier gleichbedeutend verwendet. Schlechtteile können dabei ausgeschleust werden. Die in den Übergabevorgang integrierte optische Untersuchung des Bauteils gliedert sich in mehrere Untersuchungsvorgänge auf. Sie nutzt einen oder mehrere bildgebende Sensoren zum optischen Erfassen von Deck- und/ oder Mantelfläche(n) eines Bauteils sowie der Positionen der Aufnehmer an den Übergabe-/ Empfangsstellen. Diese bildgebenden Sensoren sind dazu eingerichtet, in mehreren Untersuchungsvorgängen jeweils wenigstens ein Bild einer der Deck- und/ oder Mantelflächen eines Bauteils zu erfassen. Die Förderung / der Transport der Bauteile geschieht, während Aufnehmer von Wendeeinrichtungen jeweils ein Bauteil halten. Ein gehaltenes Bauteil passiert während des Transports einzelne Untersuchungsvorgänge. Die erfassten (Bild-)Daten der bildgebenden Sensoren dienen dabei auch dazu, die Positionsregelung der Manipulatoren (Aufnehmer) und der Empfangsstellen zu koordinieren. Die Bauteilförderung ist dazu eingerichtet, ein Bauteil im Wesentlichen kontinuierlich oder getaktet entlang seines Pfades zu fördern. Zur Selbstjustierung nutzt die Vorrichtung zumindest teilweise die im Bauteiltransferbetrieb zur Bauteilinspektion vorgesehenen bildgebenden Sensoren. Außerdem können zusätzliche bildgebende Sensoren vorgesehen sein, die jene Bereiche der Vorrichtung, an denen ein Bauteil von einem Vorrichtungsbestandteil zum einem anderen Vorrichtungsbestandteil übergeben wird, aus mindestens zwei verschiedenen Betrachtungswinkeln optisch erfassen. Die Steuerung ist dazu eingerichtet, für jede mögliche Übertragungsstellung der ersten und der zweiten Wendeeinrichtung einen, bis zu 3-dimensionalen, Korrekturvektor für jede Bauteilübergabestelle zu ermitteln, welcher im Betrieb der Bauteilhandhabungsvorrichtung jeweils dazu dient, den Fertigung- und Montageungenauigkeiten der Bauteilhandhabungsvorrichtung entgegenzuwirken.
Die hier vorgestellte komplette Baugruppe vereint funktional drei Aspekte: Handhabung, Justierung der Handhabung, und Inspektion. Diese drei Funktionen werden zur schnellen und präzisen qualitativen Beurteilung mehrerer (bis zu sechs oder mehr) Seiten der Bauteile ineinander verwoben, während diese schnell aus dem Bauteilvorrat vereinzelt entnommen und durch die Inspektion als Gutteile klassifiziert an der oder den Empfangsstellen präzise abgesetzt werden.

In einer Variante verfügt die Bauteilhandhabungsvorrichtung ausschließlich über eine erste Wendeeinrichtung, welche das Bauteil von der Abgabeeinrichtung an der Spendestelle aufnimmt, und zu der Ablagestelle fördert, um es dort auf eine Empfangseinrichtung zu übergeben.

In einer anderen Variante hat die Bauteilhandhabungsvorrichtung zwei vorzugsweise geregelt betriebene, vorzugsweise im Wesentlichen orthogonal (90° plus minus bis zu 15°) zueinander angeordnete, in etwa stern- oder radförmige Wendeeinrichtungen. Die Wendeeinrichtungen könnten auch eine rechteckige Gestalt haben. Jede dieser Wendeeinrichtungen trägt mehrere zu ihrer Drehachse radial verfahrbare Aufnehmer, um die Bauteile jeweils auf einem Aufnehmer fixiert innerhalb eines Schwenkwinkels zwischen Bauteil-Übernahme und -Übergabe einer oder mehreren Prozessstationen zur Inspektion, Schlechtteilausschleusung und ggf. weiteren Stationen zuzuführen.

Bei der hier vorgestellten Bauteilhandhabungsvorrichtung tragen die stern- oder radförmigen Wendeeinrichtungen die Bauteile an radial nach außen weisenden Aufnehmern, die am (gedachten) Umfang der beiden Wendeeinrichtungen angeordnet sind. Dies ist im Unterschied zu solchen Bauteilhandhabungsvorrichtungen zu sehen, bei denen die Aufnehmer einer oder beider Wendeeinrichtungen koplanar oder parallel zur deren Rotationsachse orientiert sind.

Während vorstehend mehrere Untersuchungsvorgänge erwähnt sind, soll damit kein zeitlicher Ablauf oder eine Reihenfolge (zuerst eine Bilderfassung in einem ersten und dann eine Bilderfassung in einem weiteren Untersuchungsvorgang) festgelegt sein. Vielmehr sind auch Fälle denkbar, in denen die umgekehrte Reihenfolge günstiger ist. Da abhängig von der Anzahl der Aufnehmer an den einzelnen Wendeeinrichtungen auch gleichzeitig mehrere Bauteile an jeder der Wendeeinrichtungen aufgenommen sein können, finden die Untersuchungsvorgänge auch zeitgleich, wenn auch an unterschiedlichen Bauteilen, statt.

Die in den einzelnen Untersuchungsvorgängen durch die bildgebenden Sensoren er-fasste(n) (oberen/unteren) Deck- und/oder (seitlichen) Mantelfläche(n) eines Bauteils können voneinander abweichende Deck- und/oder Mantelflächen des Bauteils sein.

Ein Aspekt der optischen Untersuchung sieht vor, dass die Bauteilförderung mit einem Bauteil den Bauteilpfad im Wesentlichen ohne oder nahezu ohne Stillstand absolviert. Dabei werden während der Bewegung oder während der minimalen Stillstandszeiten eine oder mehrere Deck- und/oder Mantelflächen eines Bauteils mit den bildgebenden Sensoren erfasst. Diese Bilder werden anschließend mit Methoden der Bildverarbeitung ausgewertet. Eine Variante dieser optischen Erfassung / Untersuchung sieht vor, dass als bildgebende Sensoren eine oder mehrere Farb-Kameras oder Schwarzweiß-Kameras vorgesehen sind.

Die bildgebenden Sensoren können dabei einen oder mehrere Spiegel, optische Prismen, Linsen oder dergl. haben.

Den bildgebenden Sensoren können Strahlungs- oder Lichtquellen zugeordnet sein. Dabei kann jede Quelle dazu eingerichtet sein, Licht / Strahlung mit einem unterschiedlichen Spektral- oder Wellenlängenbereich zur Beleuchtung zumindest eines Abschnitts des Bauteils abzugeben. Die Wellenlängenbereiche können zumindest teilweise voneinander abweichen, überlappen oder übereinstimmen. So kann zum Beispiel das Licht der ersten Lichtquelle rot, und das Licht der zweiten Lichtquelle kann blau sein. Es kann aber auch die umgekehrte Zuordnung oder eine andere Wellenlängenpaarung (zum Beispiel infrarotes und sichtbares Licht) gewählt sein.

Die Lichtquellen können durch eine Steueranordnung in dem Moment jeweils kurz eingeschaltet werden, wenn sich der Aufnehmer mit dem Bauteil im jeweiligen Erfassungsbereich befindet, so dass die Deck- und/oder Mantelflächen des Bauteils mit einem kurzen Lichtblitz zur Erfassung durch den jeweiligen bildgebenden Sensor belichtet werden können. Alternativ kann eine dauerhafte Beleuchtung verwendet werden.

Der Bauteilhandhabungsvorrichtung ist in einer Variante eine Abgabeeinrichtung zugeordnet, die dazu eingerichtet ist, jeweils ein Bauteil aus dem strukturierten Bauteilvorrat an einen durch die Steuerung entsprechend positionierten Aufnehmer der ersten Wendeeinrichtung abzugeben. Dies kann ein Bauteil-Ausstoßer (die ejector) sein, der das Bauteil durch die Waferträgerfolie hindurch mittels einer Nadel abstößt oder ein Laserpulsgeber, der den Haftkleber des Bauteils an der Trägerfolie gezielt zum Schmelzen bringt. Der Abgabeeinrichtung ist ein Lage- und/oder Eigenschaftssensor zugeordnet, der dazu eingerichtet ist, die Lage der Abgabeeinrichtung relativ zu dem abzugebenden Bauteil und/oder Lagedaten des abzugebenden Bauteils, und/oder Eigenschaften des abzugebenden Bauteils zu erfassen und für die Steuerung zum Betätigen der Abgabeeinrichtung zur Verfügung zu stellen.

In einer Variante ist dieser Lage- und/oder Eigenschaftssensor dazu eingerichtet, eine Position eines Aufnehmers der ersten Wendeeinrichtung relativ zur Abgabeeinrichtung zu bestimmen und der Steuerung zur Selbstjustierung der Bauteilhandhabungsvorrichtung zur Verfügung zu stellen.

Der Bauteilhandhabungsvorrichtung ist in einer Variante mit einer der Ablagestelle zugeordneten Empfangseinrichtung für ein dorthin gefördertes Bauteil ausgestattet. Der Empfangseinrichtung sind dabei Lage- und/oder Eigenschaftssensoren zugeordnet, die dazu eingerichtet sind, Lagedaten des an die Ablagestelle geförderten Bauteils, Lagedaten und/oder Eigenschaften von Empfangsstellen in der Empfangseinrichtung und/oder darin befindlichen Bauteils zu erfassen und für eine Steuerung zur Verfügung zu stellen.

In einer Variante sind die Lage- und/oder Eigenschaftssensoren dazu eingerichtet, eine Position der Empfangsstelle relativ zu einem Aufnehmer der zweiten Wendeeinrichtung zu bestimmen und der Steuerung zur Selbstjustierung der Bauteilhandhabungsvorrichtung zur Verfügung zu stellen.

Die Steuerung ist dazu eingerichtet, mittels eines dritten Drehantriebes die Empfangseinrichtung zumindest teilweise um eine die Ablagestelle enthaltende dritte Achse kontrolliert zu drehen. Die Steuerung kann auch dazu eingerichtet sein, die Empfangseinrichtung mittels wenigstens eines dritten Linearantriebes zumindest teilweise längs einer Achse kontrolliert zu verfahren. Schließlich kann die Steuerung auch dazu eingerichtet sein mittels eines Linearantriebes einen durch die Empfangseinrichtung geführten Träger längs einer der ersten und/oder zweiten Achsen kontrolliert zu verfahren. Dieser Träger dient dazu, die Bauteile in vereinzelter Form aufzunehmen.

Bei der Bauteilhandhabungsvorrichtung sind in einer Variante die Aufnehmer der ersten und/oder der zweiten Wendeeinrichtung dazu eingerichtet, radial zur Drehachse oder das Drehzentrum der jeweiligen Wendeeinrichtung kontrolliert aus- und eingefahren zu werden, und/ oder zum Empfangen und Abgeben eines zu fördernden Bauteils kontrolliert mit Unterdruck und/oder Überdruck beaufschlagt zu werden, und/ oder um ihre jeweilige radiale Bewegungsachse unbeweglich zu sein, oder um ihre jeweilige radiale Bewegungsachse um einen Drehwinkel kontrolliert gedreht zu werden.

Bei einer Bauteilhandhabungsvorrichtung dieser Art sind in einer Variante den Aufnehmern der ersten und/oder der zweiten Wendeeinrichtung zum radialen Aus-/Einfahren bei der Spendestelle, der Übergabestelle zwischen den ersten und zweiten Wendeeinrichtungen diesen zugeordnete Linearantriebe vorgesehen. Diese Linearantriebe greifen in die entsprechend positionierten Aufnehmer jeweils von außerhalb der jeweiligen Wendeeinrichtungen ein und fahren den jeweiligen Aufnehmer radial aus- und ein. In einer anderen Variante fahren diese Linearantriebe den jeweiligen Aufnehmer lediglich aus, während eine Rückstellfeder den jeweiligen Aufnehmer einfährt. In einer weiteren Variante ist jedem der Aufnehmer ein bidirektionaler oder unidirektionaler Radialantrieb zugeordnet.

In einer Variante der Bauteilhandhabungsvorrichtung stellen Ventile zu jedem der einzelnen Aufnehmer individuell und positionsgerecht eine Zuführung von Unterdruck und Überdruck bereit um frei oder positionsgesteuert die Funktionen: (i) Ansaugen des Bauteils, (ii) Halten des Bauteils, (iii) Ablegen des Bauteils mit oder ohne gesteuertem Abblas-Impuls, und/oder freies Abblasen des Bauteils zu realisieren.

In einer Variante der Bauteilhandhabungsvorrichtung sind der ersten Wendeeinrichtung zwischen der Spendestelle und der Übergabestelle, und/oder der zweiten Wendeeinrichtung zwischen der Übergabestelle und der Ablagestelle jeweils Lage- und Eigenschaftssensoren zugeordnet. Diese Sensoren sind dazu eingerichtet, Lagedaten und/oder Eigenschaften des geförderten Bauteils und/oder Positionsdaten zur Lageregelung der Manipulatoren (Aufnehmer) und der Empfangsstellen zu erfassen und für die Steuerung zur Verfügung zu stellen.

In einer Variante sind diese Sensoren dazu eingerichtet, eine Position eines Aufnehmers der ersten Wendeeinrichtung relativ zu einem zuvor definierten Referenzpunkt zu bestimmen und/oder eine Position eines Aufnehmers der zweiten Wendeeinrichtung zu einem zuvor definierten Referenzpunkt zu bestimmen und diese relativen Positionen der Steuerung zur Selbstjustierung der Bauteilhandhabungsvorrichtung zur Verfügung zu stellen.

In einer Variante werden die relativen Positionen der Aufnehmer der ersten und/oder zweiten Wendeeinrichtung zu den definierten Referenzpunkten mit den relativen Positionen der Aufnehmer zueinander und/oder zur Abgabeeinrichtung und/oder zur Empfangsstelle für jeden Aufnehmer jeweils durch die Steuerung verglichen, um die Erfassungsqualität der Sensoren und/oder die Beschädigungsfreiheit der Aufnehmer zu überprüfen.

In einer Variante der Bauteilhandhabungsvorrichtung sind wenigstens einige der Lage- und Eigenschaftssensoren dazu eingerichtet, jeweils wenigstens eine Deckfläche und/oder eine oder mehrere Mantelflächen des geförderten Bauteils zu inspizieren um dessen Lagedaten und/oder Eigenschaften zu erfassen und für die Steuerung zur Verfügung zu stellen.

In einer Variante der Bauteilhandhabungsvorrichtung sind im Zentrum der ersten Wendeeinrichtung und/oder im Zentrum der zweiten Wendeeinrichtung jeweils wenigstens ein bildgebender Eigenschafts- und/oder Lagesensor zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils vorgesehen. Basierend auf den Eigenschaftsdaten und/oder den Lagedaten des Sensors / dieser Sensoren kann dann eine Korrektur bei Eigenschaftsfehlern und/oder Lagefehlern des zu empfangenden Bauteils bzw. der Empfangsstelle durch die Steuerung erfolgen. Dabei ist/sind in einer Variante der/die bildgebende/n Lagesensor/en dazu eingerichtet, einen Bildeinzug jeweils während der Wendebewegung der ersten bzw. zweiten Wendeeinrichtung zwischen benachbarten Aufnehmern auszuführen und für die Steuerung zur Veranlassung entsprechender Korrekturbewegungen der Ausstoßeinheit, dem Bauteilvorrat oder Wafer, der Wendeeinrichtungen und/oder der Empfangseinrichtung zur Verfügung zu stellen. In einer anderen Variante ist die Ausstoßeinheit feststehend. In einer anderen Variante verfügt/verfügen der/die im Zentrum der ersten/zweiten Wendeeinrichtung positionierte/n bildgebende/n Lage- und/oder Eigenschaftssensor/en über eine Reflektoranordnung, welche die indirekte Erfassung der Ausstoßeinheit, des Bauteilvorrats oder Wafers, der Aufnehmer der ersten/zweiten Wendeeinrichtung und/oder der Empfangseinrichtung erlaubt, während sich die Wendeeinrichtungen in einer zur Übertragung von Bauteilen vorgesehenen Position (Übertragungsstellung) befinden.

In einer Variante ist der Lage- und/oder Eigenschaftssensor im Zentrum der ersten Wendeeinrichtung dazu eingerichtet, eine Position eines Aufnehmers der ersten Wendeeinrichtung relativ zur Abgabeeinrichtung zu bestimmen und der Steuerung zur Selbstjustierung der Bauteilhandhabungsvorrichtung zur Verfügung zu stellen.

In einer Variante ist im Zentrum der ersten Wendeeinrichtung ein weiterer Lage- und/oder Eigenschaftssensor vorgesehen, der dazu eingerichtet ist, eine Position eines Aufnehmers der zweiten Wendeeinrichtung relativ zur Position eines Aufnehmers der ersten Wendeeinrichtung zu bestimmen und der Steuerung zur Selbstjustierung der Bauteilhandhabungsvorrichtung zur Verfügung zu stellen.

In einer Variante ist der Lage- und/oder Eigenschaftssensor im Zentrum der zweiten Wendeeinrichtung dazu eingerichtet, eine Position der Empfangsstelle relativ zu einem Aufnehmer der zweiten Wendeeinrichtung zu bestimmen und der Steuerung zur Selbstjustierung der Bauteilhandhabungsvorrichtung zur Verfügung zu stellen.

In einer Variante ist im Zentrum der zweiten Wendeeinrichtung ein weiterer Lage- und/oder Eigenschaftssensor vorgesehen, der dazu eingerichtet ist, eine Position eines Aufnehmers der zweiten Wendeeinrichtung relativ zur Position eines Aufnehmers der ersten Wendeeinrichtung zu bestimmen und der Steuerung zur Selbstjustierung der Bauteilhandhabungsvorrichtung zur Verfügung zu stellen.

Zusätzlich oder alternativ zu diesen bildgebenden Eigenschafts- und/oder Lagesensoren können relativ zu den ersten und zweiten Wendeeinrichtungen extern vorgesehene bildgebende Eigenschafts- und/oder Lagesensoren zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils vorgesehen sein. Basierend auf den Eigenschaftsdaten und/oder den Lagedaten dieses Sensors / dieser Sensoren kann dann eine Korrektur bei Eigenschaftsfehlern und/ oder Lagefehlern des zu empfangenden Bauteils bzw. der Empfangsstelle durch die Steuerung erfolgen. Unabhängig von dem vorstehend beschriebenen Inspektionssystem und funktional als Bestandteil dem Handhabungssystem zuzuordnen, können jeweils im Zentrum der beiden Wendeeinrichtungen eine nach oben gerichtete Bauteilvorrats-Kamera (mit 90°-Spiegelsystem und Beleuchtung) bzw. eine bevorzugt aber nicht zwingend baugleiche nach unten gerichtete Baugruppe als Ablege-Kamera angeordnet sein. Sie dienen zur Positionserfassung der Bauteile bzw. der Empfangsstellen mit dem Ziel der Positionskorrektur bei auftretenden Lagefehlern der Bauteile bzw. der Empfangsstellen. In einer Variante können die Sensoren zur Selbstjustierung der Bauteilhandhabungsvorrichtung miteingebunden werden.

In einer Variante sind mindestens 2 extern vorgesehene bildgebende Eigenschafts - und/oder Lagesensoren aus im Wesentlichen zueinander orthogonalen Betrachtungsrichtungen (90° plus/minus 15°) auf die Spendestelle der Bauteile gerichtet und dazu eingerichtet, eine Position eines Aufnehmers der ersten Wendeeinrichtung relativ zur Abgabeeinrichtung zu bestimmen und der Steuerung zur Selbstjustierung der Bauteilhandhabungsvorrichtung zur Verfügung zu stellen.

In einer Variante sind mindestens 2 extern vorgesehene bildgebende Eigenschafts - und/oder Lagesensoren aus im Wesentlichen zueinander orthogonalen Betrachtungsrichtungen (90° plus/minus 15°) auf die Übergabestelle der Bauteile gerichtet und dazu eingerichtet, eine Position eines Aufnehmers der zweiten Wendeeinrichtung relativ zur Position eines Aufnehmers der ersten Wendeeinrichtung zu bestimmen und der Steuerung zur Selbstjustierung der Bauteilhandhabungsvorrichtung zur Verfügung zu stellen.

In einer Variante sind mindestens 2 extern vorgesehene bildgebende Eigenschafts - und/oder Lagesensoren aus im Wesentlichen zueinander orthogonalen Betrachtungsrichtungen (90° plus/minus 15°) auf die Ablagestelle der Bauteile gerichtet und dazu eingerichtet, eine Position der Empfangsstelle relativ zu einem Aufnehmer der zweiten Wendeeinrichtung zu bestimmen und der Steuerung zur Selbstjustierung der Bauteilhandhabungsvorrichtung zur Verfügung zu stellen.

In einer Variante der Bauteilhandhabungsvorrichtung ist der Übergabestelle und/oder der Ablagestelle eine Ausschleusstelle vor- oder nachgelagert, die dazu eingerichtet ist, durch die Steuerung gesteuert, ein durch die Steuerung mittels wenigstens eines der Lage- und Eigenschaftssensoren als Schlechtteil erkanntes Bauteil auszuschleusen, und es nicht als Gutteil in die Empfangseinrichtung abzulegen.
In einer Variante der Bauteilhandhabungsvorrichtung sind der ersten und/oder der zweiten Wendeeinrichtung jeweils eine ganzzahlige Anzahl von n Aufnehmern zugeordnet. Dabei gilt n >= 2. Die Anzahl der Aufnehmer der ersten Wendeeinrichtung und die Anzahl der Aufnehmer der zweiten Wendeeinrichtung können dabei gleich oder unterschiedlich sein.

In einer Variante der Bauteilhandhabungsvorrichtung schließen die ersten, zweiten und/oder dritten Achsen zueinander jeweils einen Winkel von 90° plus/minus maximal 10° oder 15° ein.

In einer Variante der Bauteilhandhabungsvorrichtung sind die Lage-/Eigenschaftssensoren bildgebende Sensoren mit übereinstimmenden oder voneinander abweichenden Erfassungsspektren, oder berührend oder berührungslos distanzmessende Lagesensoren, oder berührend oder berührungslos erfassende Eigenschaftssensoren.

Die Lage- und Eigenschaftssensoren können bildgebende Sensoren mit geradlinigen oder abknickenden optischen Achsen sein.

Die Kamera-Systeme der Lage- und Eigenschaftssensoren einschließlich ihrer Spiegel- und Beleuchtungseinheiten können durch ihre räumliche Anordnung derart kombiniert sein, dass die Bauteil-Inspektion der jeweils zugewandten Bauteilfläche und zweier seiner Mantelflächen parallelisiert an einer einzigen Prozessposition realisierbar ist. Insgesamt genügen zwei Prozesspositionen zur kompletten Inspektion aller sechs Seitenflächen eines zum Beispiel quaderförmigen Bauteils. Dazu werden an jeder der beiden Prozesspositionen von dem Bauteil drei der sechs Seitenflächen erfasst. Als Inspektionsposition einer jeden Wendeeinrichtung kann in einer Variante dabei die jeweils dritte Prozessposition in etwa horizontal auf Höhe der Rotations- oder Schwenkachse festgelegt sein.

Zusätzliche positionsmessende Aufgaben können zwei weiteren Kamera-Systemen (Vorder-/Rückseiten-Kamera) zugeordnet sein.

In einer Variante der Bauteilhandhabungsvorrichtung sind die ersten und/oder zweiten Wendeeinrichtungen zumindest annähernd stern- oder radförmig ausgestaltet. Die Wendeeinrichtungen können präzisionsgelagert sein und ihre Positionierung längs der jeweiligen Achsen bzw. um die jeweiligen Achsen kann mittels axial angeordnetem linear bzw. rotatorisch wirkendem Antrieb erfolgen, gepaart mit einem hochauflösenden (zum Beispiel rotatorischen oder linearen) Encoder. Die jeweiligen Aufnehmer können am äußeren Umfang verteilt angeordnet sein und radial nach außen weisende Saugkontaktstellen für die zu fördernden Bauteile haben.

Ein Vorteil der axial um etwa 90° versetzten Anordnung der Wendeeinrichtungen zueinander besteht darin, dass die Bauteile in ihrer Lage während des Förder-Prozesses bei Übergabe von einer Wendeeinrichtung zur nächsten eine 90°-Drehung um die Aufnehmerachse, relativ zur jeweiligen Bewegungsebene der Aufnehmer (bzw. Wendeeinrichtung-Achse) ausführen, ohne, dass dafür der Aufnehmer selbst rotatorisch verfahrbar gelagert werden muss. Diese Orientierungsänderung der Bauteile ermöglicht wiederum eine wesentliche vereinfachte Inspektion der vier Bauteil-Schnittflächen (=Bauteilseitenflächen). Hierfür dient ein durch je ein, der Bauteil-Schnittfläche zugewandtes, orthogonal zur Aufnehmer-Bewegungsebene (also in axialer Richtung der Wendeeinrichtung) angeordnetes Kamera-System mit vorzugsweise sehr geringem Abstand zu den Bauteil-Schnittflächen (= Mantelflächen des Bauteils) selbst.

Die Erfassung der Fehlpositionierung von Aufnehmer und Bauteil zueinander bzw. zu den Übergabe- und Inspektionspositionen erfolgt unter Nutzung der Kamera- Systeme als Aufnehmer- bzw. Bauteil-Lage-erfassendes Messsystem. Bei sehr hohen Genauigkeitsanforderungen können zusätzlich jeweils drei distanzmessende Sensoren für die Bondtool-Lageerfassung je Wendeeinrichtung zusätzlich vorgesehen sein.

Die optischen Achsen der Kameras "durchdringen" die inspizierte Bauteil-Oberfläche. Sie bilden ein Bezugssystem für die Aufnehmer-Lage. Hiervon abgeleitet lassen sich durch die in einer Ebene parallel zur idealen Aufnehmer-Bewegungsebene der rotierenden Wendeeinrichtung angeordneten distanzmessenden Sensoren Abweichungen der Aufnehmer-Bewegungsbahn von der Soll-Bewegungsbahn ermitteln. Daraus sind die auftretenden Positionsfehler in den Übergabepositionen bestimm- und durch die Steuerung kompensierbar.

Je nach verwendeten optischen Lage-/Eigenschaftssensoren und/oder Funktionsprinzip der zusätzlichen Lagesensoren lassen sich die Referenzmessungen zur Aufnehmer-Lage und/oder die Selbstjustierung im laufenden Prozess oder auch während zyklisch sich wiederholender Referenzfahrten (zum Beispiel mittels tastend berührender Messsensoren erforderlich) realisieren. Dafür sind sowohl zu Prozessbeginn zur Erfassung räumlicher Lagefehler, als auch während des Prozesses zur Einbeziehung thermisch bedingter Verlagerungen zyklische Referenzfahrten (bei berührenden Sensoren mit kurzzeitiger Prozessunterbrechung) erforderlich, wobei letztere auch relativ lang sein können.

In einer Variante der Vorrichtung lässt sich die Selbstjustierung vor Inbetriebnahme der Bauteilhandhabungsvorrichtung durchführen. Die Steuerung ist hierbei dazu eingerichtet, jeweils die erste und zweite Wendeeinrichtung sukzessive zu rotieren und mit den optischen Lage- und Eigenschaftssensoren und/oder den zusätzlichen Lagesensoren zunächst eine relative Position eines jeden einzelnen Aufnehmers der ersten Wendeeinrichtung zur Abgabeeinrichtung zu ermitteln, eines jeden einzelnen Aufnehmers der zweiten Wendeeinrichtung zu dem jeweils an der Übergabestelle gegenüberliegenden Aufnehmer der ersten Wendeeinrichtung zu ermitteln und die Position der Empfangsstellen jeweils zu dem an der Ablagestelle befindlichen Aufnehmer der zweiten Wendeeinrichtung zu ermitteln. Die Steuerung ist hierbei dazu eingerichtet, das sukzessive Rotieren der Wendeeinrichtungen und das ermitteln der relativen Positionen mindestens so oft zu wiederholen, bis alle möglichen Stellungen der Wendeeinrichtungen zur Abgabeeinrichtung, zueinander und zur Empfangseinrichtung mindestens einmal erreicht wurden. Die Steuerung ist hierbei weiter dazu eingerichtet, die ermittelten Werte in einer Steuerungstabelle zu speichern.

Die ermittelten Positionsabweichungen der an der Spendestelle befindlichen Aufnehmer der ersten Wendeeinrichtung relativ zu einer zuvor definierten Position zur Abgabeeinrichtung bilden im Betrieb jeweils den Korrekturvektor für die erste Wendeeinrichtung.

Die ermittelten Positionsabweichungen der Aufnehmer der zweiten Wendeeinrichtung relativ zu einer zuvor definierten Position zu dem jeweils an der Übergabestelle gegenüberliegenden Aufnehmer der ersten Wendeeinrichtung bilden, addiert mit dem jeweiligen Korrekturvektor für die erste Wendeeinrichtung, den jeweiligen Korrekturvektor der zweiten Wendeeinrichtung.

Die ermittelten Positionsabweichungen der Empfangestelle relativ zu einer zuvor definierten Position zu dem jeweils an der Ablagestelle gegenüberliegenden Aufnehmer der zweiten Wendeeinrichtung bilden, addiert mit dem jeweiligen Korrekturvektor der zweiten Wendeeinrichtung, den jeweiligen Korrekturvektor der Empfangseinrichtung.

In einer Variante wird zur Kompensation von, insbesondere durch die Selbstjustierung bestimmten, Positionsfehlern der Wendeeinrichtungen der Aufnehmer insbesondere in den Bauteil-Übergabepositionen und der Positionierungsfehler der darauf fixierten Bauteile (in Übergabe und Inspektionspositionen) eine rotatorische Korrekturbewegung des Rotorantriebes und orthogonal eine lineare Korrekturbewegung in Achsrichtung ausgeführt. Hierfür kann in einer Variante die Rotor-Antriebsbaugruppe auf einem Verfahrschlitten angeordnet sein und mittels eines positionsgeregelten Antriebes, zum Beispiel eines Exzenterantriebes um begrenzte Wegsegmente verfahren werden.

In einer Variante der Bauteilhandhabungsvorrichtung erfordert die starre Kopplung mehrerer Aufnehmer an einer Wendeeinrichtung eine Übertragung der Korrekturwerte von einer Bauteil-Übergabe-Position bzw. Inspektionsposition zu den in der Abfolge nächsten Positionen. Diese Korrekturen können an einer fixen Übergabeposition beginnen und bei der letzten Bauteil-Übergabe in die Empfangsstelle enden. Dabei werden die summarischen Lagefehler entlang der bis zu drei Achsen und die Verdrehung um die bis zu drei Achsen durch die Empfangseinrichtung kompensiert.

In einer Variante der Bauteilhandhabungsvorrichtung sind die Aufnehmer an ihrer jeweiligen Wendeeinrichtung nicht drehbar gelagert. So kann ein Orientierungsfehlerausgleich von Bauteilen während des Förderns selbst nicht erfolgen. Daher ist in einer Variante im nachgelagerten Peripheriebereich, insbesondere in der Empfangseinrichtung neben der Achsen-Lagekorrektur auch eine rotatorische Korrekturmöglichkeit vorzusehen.

In einer anderen Variante der Bauteilhandhabungsvorrichtung erfolgt die Rotationskorrektur mit drehbar gelagerten Aufnehmern. Damit kann ein Ausgleichen von Orientierungsfehlern von Bauteilen während des Förderns selbst erfolgen. Der Orientierungsfehler wird dann durch die drehbar gelagerten Aufnehmer der oberen und/oder unteren Wendeeinrichtung korrigiert, bevorzugt durch die Aufnehmer der unteren Wendeeinrichtung.

Die hier vorgestellten Varianten sind im Vergleich zum Stand der Technik kostengünstiger und bieten einen höheren Bauteiledurchsatz, mehr Zeit für Inspektionen und haben weniger bewegte Massen.

Ein Verfahren zum Selbstjustieren der Bauteilhandhabungsvorrichtung weist folgende Schritte auf:
- Erfassen der Spendestelle, beinhaltend die Abgabeeinrichtung und den an dieser Stelle befindlichen Aufnehmer, aus mindestens zwei voneinander verschiedenen Erfassungsrichtungen, durch mindestens einen optischen Lage- oder Eigenschaftssensor.
- Erfassen der Übergabestelle, beinhaltend den an dieser Stelle befindlichen Aufnehmer der ersten Wendeeinrichtung und den an dieser Stelle befindlichen Aufnehmer der zweiten Wendeeinrichtung, aus mindestens zwei voneinander verschiedenen Erfassungsrichtungen, durch mindestens einen optischen Lage- oder Eigenschaftssensor.
- Erfassen der Ablagestelle, beinhaltend den an dieser Stelle befindlichen Aufnehmer und die Empfangsstelle, aus mindestens zwei voneinander verschiedenen Erfassungsrichtungen, durch mindestens einen optischen Lage- oder Eigenschaftssensor.
- Ermitteln der Position des an der Spendestelle befindlichen Aufnehmers in Relation zur Abgabeeinrichtung, und ermitteln einer Abweichung zu einer zuvor definierten Position des Aufnehmers.
- Ermitteln der Position des an der Übergabestelle befindlichen Aufnehmers der zweiten Wendeeinrichtung in Relation zum Aufnehmer der ersten Wendeeinrichtung, und ermitteln einer Abweichung zu einer zuvor definierten Position des Aufnehmers der zweiten Wendeeinrichtung.
- Ermitteln der Position der Empfangsstelle in Relation zu dem an der Ablagestelle befindlichen Aufnehmer und ermitteln eine Abweichung zu einer zuvor definierten Position der Empfangsstelle.
- Ermitteln, anhand der zuvor ermittelten jeweiligen Abweichungen, eines Korrekturvektors für die erste Wendeeinrichtung und/oder eines Korrekturvektors für die zweite Wendeeinrichtung und/oder eines Korrekturvektors für jeden einzelnen Aufnehmer und/oder eines Korrekturvektors für die Empfangseinrichtung.
- Wiederholung aller vorherigen Verfahrensschritte für jede mögliche Übertragungsstellung der ersten und/oder der zweiten Wendeeinrichtung.
- Überprüfung der Erfassungsqualität der Sensoren und/oder der Aufnehmer auf Beschädigungsfreiheit, indem die ermittelten relativen Positionen der Aufnehmer zur Abgabeeinrichtung, zueinander und zu den Empfangsstellen mit den relativen Positionen der Aufnehmer zu einem definierten Referenzpunkt hin verglichen werden. Die Position der Aufnehmer zu den Referenzpunkten (je einer für die erste und die zweite Wendeeinrichtung) wird hierbei durch die Lage- und Eigenschaftssensoren ermittelt, welche sich zwischen Spendestelle und Übergabestelle (für die erste Wendeeinrichtung) bzw. zwischen Übergabestelle und Ablagestelle (für die zweite Wendeeinrichtung) befinden.
- Steuern der Positionierung der ersten Wendeeinrichtung und/oder der zweiten Wendeeinrichtung und/oder der Empfangseinrichtung und/oder jedes einzelnen Aufnehmers während des Betriebs der Bauteilhandhabungsvorrichtung so, dass der Abweichung zwischen den ermittelten und den zuvor definierten Positionen der Aufnehmer und/oder der Empfangsstelle entgegengewirkt wird.

Genauer wird eine Lösung für eine Empfangseinrichtung, insbesondere für eine Bauteilhandhabungsvorrichtung der oben vorgestellten Art vorgestellt, die dazu eingerichtet ist, relativ zu der Ablagestelle mittels eines Drehantriebes zumindest teilweise um eine die Ablagestelle enthaltende dritte Achse kontrolliert zu drehen, und/oder mittels wenigstens eines Linearantriebes zumindest teilweise längs einer der ersten, zweiten und/oder dritten Achsen kontrolliert zu verfahren, und/oder mittels eines Drehantriebes einen durch die Empfangseinrichtung geführten Träger längs einer der ersten und/oder zweiten Achsen kontrolliert zu verfahren.

Die hier vorgestellte Lösung erlaubt, die Position und Lage der Wendeeinrichtungen simultan durch Position und/oder Rotation der Empfangseinrichtung zu kompensieren. Deshalb kann der Bauteiledurchsatz der Maschine gegenüber dem Stand der Technik erhöht werden. Um Spiel im Bandantrieb des Ablagebandes zu vermeiden, müssen im Stand der Technik die Antriebe relativ zueinander eingestellt werden. Die hier vorgestellte Lösung vermeidet dies, da der Transport immer nur in eine Richtung erfolgt. Dies ist insbesondere in Anwendungen hilfreich, bei denen die Taschen des Trägerbandes mit einem klebenden Abdeckband nach und nach verschlossen werden. Würde man das Trägerband wieder zurücktransportieren, ergäben sich evtl. Probleme, wenn das Abdeckband wieder abzulösen wäre. Das Spiel im Antrieb kann dabei vernachlässigt werden.

In einer anderen Variante kann auch in die entgegengesetzte Richtung transportiert werden.

Die Korrektur der Position des Bauteils erfolgt an der Empfangseinrichtung. So steht mehr Zeit dafür zur Verfügung. Ein Rück-Transport des Bandes, in dem die Bauteile abgelegt werden, ist nicht mehr erforderlich. Damit kann die Empfangseinrichtung einfacher aufgebaut sein. Ein zweites Antriebsrad für den Rücktransport des Bandes wie beim Stand der Technik ist nicht mehr erforderlich. Vielmehr wird in den erforderlichen Situationen die gesamte Empfangseinrichtung entgegen der Transportrichtung des Ablagebandes bewegt. Der Vorteil ist, dass eine höhere Positioniergenauigkeit des Bandes gegenüber vorbekannten Varianten erreicht wird, in denen die Positionierung ausschließlich über den Transport des Transportbandes bewerkstelligt wird. Auch das nachfolgende Anbringen eines (selbstklebenden) Abdeckbandes (Cover-Tape) auf dem Transportband kann hierbei leichter erfolgen.

In einer Variante ist die Empfangseinrichtung oberhalb einer ortsfesten Grundplatte angeordnet, die Motoren der drei Antriebe sind unterhalb der Grundplatte angeordnet. Die Position der Empfangseinrichtung kann in X, Y und um die Z-Achse rotierend justiert werden. Jede Bewegungsrichtung der Empfangseinrichtung verfügt über einen eigenen Antrieb. Die Position der einzelnen Antriebe ist nicht festgelegt. Die Drehachse für die Z-Korrektur liegt nahe bei der Bauteil-Ablageposition oder fällt in deren Zentrum.

In einer Variante der Empfangseinrichtung ist diese mit zwei Empfangsstellen ausgestattet, welche zu der Ablagestelle durch kontrolliertes Betätigen des Drehantriebes des/der Linearantriebe zumindest annähernd fluchtend auszurichten sind. Die zwei Empfangsstellen sind einem Rastermaß benachbarter Bauteil-Aufnahmen des Trägers entsprechend zueinander zu positionieren.

In einer Variante der Empfangseinrichtung ist ein bildgebender Eigenschafts- und/ oder Lagesensor zum Ermitteln von Eigenschaften und/oder der Lage eines zu empfangenden Bauteils in Bezug auf dessen Eigenschaften und/oder seiner Lage zu wenigstens einer der Empfangsstellen in der Empfangseinrichtung vorgesehen. Dieser bildgebende Eigenschafts- und/ oder Lagesensor befindet sich im oder beim Zentrum der unteren Wendeeinrichtung. Mit den Bilddaten aus diesem Sensor kann die Erzeugung von Korrekturanweisungen bei Eigenschafts- und/oder Lagefehlern des zu empfangenden Bauteils bzw. der Empfangsstelle durch die Steuerung zur Veranlassung entsprechender Korrekturbewegungen erfolgen.

In einer anderen Variante sind zwei weitere bildgebende Eigenschafts- und/ oder Lagesensoren bei der Empfangseinrichtung vorgesehen. Der eine Sensor ist von oben auf das zweite Fenster gerichtet um Qualitätsfehler zu untersuchen. Der andere Sensor ist beim ersten Fenster seitlich angeordnet um ein Verkippen des Bauteils besser gegenüber dem oben erläuterten Sensor detektieren zu können.

In einer Variante der Empfangseinrichtung ist der vierte Drehantrieb dazu eingerichtet, durch Steuersignale aus der Steuerung angesteuert, mittels einer mechanischen Traktion den durch die Empfangseinrichtung geführten Träger längs einer der ersten und/oder zweiten Achsen kontrolliert um etwa 80 - 120%, vorzugsweise etwa 100% plus minus maximal 3%, des Rastermaßes benachbarter Bauteil-Aufnahmen des Trägers zu verfahren. Dabei kann auch der Drehantrieb dazu eingerichtet sein, durch Steuersignale aus der Steuerung angesteuert, in Abhängigkeit von Signalen aus dem bildgebenden Eigenschafts- und/oder Lagesensor wenigstens eine der Empfangsstellen mit der dort befindlichen Bauteil-Aufnahme des Trägers um die die Ablagestelle enthaltende dritte Achse kontrolliert um bis zu plus minus 6 °, vorzugsweise um bis zu plus minus 3 ° zu drehen. Des Weiteren kann ergänzend oder alternativ der wenigstens eine Linearantrieb dazu eingerichtet sein, durch Steuersignale aus der Steuerung angesteuert, die Empfangseinrichtung kontrolliert um etwa plus minus maximal 20%, vorzugsweise um bis zu plus minus 3% des Rastermaßes benachbarter Bauteil-Aufnahmen des Trägers längs einer der ersten, zweiten und/oder dritten Achsen kontrolliert zu verfahren.

In einer Variante der Empfangseinrichtung ist der vierte Drehantrieb dazu eingerichtet, den durch die Empfangseinrichtung geführten Träger entsprechend einem Rastermaß benachbarter Bauteil-Aufnahmen des Trägers längs einer der ersten und/oder zweiten Achsen vorwärts zu fördern.

In einer Variante der Empfangseinrichtung ist eine Absaug- und/oder Ausblaseinrichtung vorgesehen, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen.

Im Betrieb einer Variante der Empfangseinrichtung greift ein durch den vierten Drehantrieb angetriebenes Stachelrad in Transportlöcher des Ablagebandes für dessen Transport in Förderrichtung ein. Das Stachelrad dreht dabei bevorzugt nur in eine Vorwärts-Richtung. Das Ablageband hat in regelmäßigen Abständen Ablagetaschen für die Bauteile. Pro Ablagetasche dreht das Stachelrad um einen festen Winkelbetrag (z.B. 30°, 60°, 90°, 180° ..., 360°). Aus der Bildaufnahme durch die Kamera im Zentrum der zweiten Wendeeinrichtung ist die Lage der Ablagetasche bekannt, in welche das Bauteil abgelegt wurde. Durch die Kamera am Außenumfang der zweiten Wendeeinrichtung ist überdies bekannt, ob das nächste abzulegende Bauteil am Aufnehmer verdreht gehalten wird. Aus diesen Lageinformationen wird in der Steuerung errechnet, um welche Strecken- und/oder Winkel-Beträge die Empfangseinrichtung umpositioniert werden muss. Außerdem wird bei der Positionierung der Empfangseinrichtung auch berücksichtigt, dass sich die Wendeeinrichtung in x- und y-Richtung entsprechend bewegen wird, um das Bauteil an der Übergabeposition von der oberen zur unteren Wendeeinrichtung korrekt zu übernehmen. Die Empfangseinrichtung wird dann, soweit notwendig, entlang der (X-, Y-)Achsen linear verfahren und ggf. rotiert um die Feinjustierung der Ablage des Bauteils sicherzustellen.

Wenn ein Bauteil in der Ablageposition abgelegt wurde, hat die Kamera im Zentrum der darüber angeordneten zweiten Wendeeinrichtung auch erfasst, ob das Bauteil fehlerhaft ist, d.h. ob es durch das Ablegen beschädigt wurde oder schon vorher einen Defekt hatte. Sofern bereits vorher ein Bauteil als defekt erkannte wurde, wird es nicht abgelegt.

Die Ablageposition in der Empfangseinrichtung kann gleichzeitig auch eine erste Absaugposition sein. Dazu ist an der Empfangseinrichtung ein Absauger mit Unterdruck an der Ablageposition angeordnet. In Förderrichtung des Trägerbandes gibt es eine zweite alternative Absaugposition. Das heißt, an der Empfangseinrichtung sind zwei Fenster vorgesehen: ein erstes Fenster mit einer Ablageposition und ein zweites Fenster mit einer Absaugposition. Der Abstand zwischen beiden Fenstern entspricht dem Rastermaß des Trägerbandes und ist auf das Rastermaß einstellbar. Wurde das Bauteil nicht korrekt abgelegt, so dass es schräg darin liegt, oder noch teilweise herausragt, wird dies durch eine Kamera im Zentrum der zweiten Wendeeinrichtung erkannt. Das Trägerband kann aufgrund des nicht korrekt abgelegten Bauteils nicht weitertransportiert werden. Deshalb wird das Bauteil an der Ablageposition abgesaugt und durch das nächste abzulegende Bauteil ersetzt. Ist das Bauteil beschädigt, kann es an dieser Position ebenfalls entfernt und durch das nächste abzulegende Bauteil ersetzt werden. An der Position des zweiten Fensters kann - ggf. mit einer weiteren Kamera - auf Fehler inspiziert werden. Bei einem als defekt erkanntem Bauteil wird die Empfangseinrichtung insgesamt zurückbewegt und an das als defekt erkannte Bauteil an der Ablageposition abgesaugt.

Alternativ kann die zweite Absaugposition verwendet werden, um das als defekt erkannte Bauteil zu entfernen.

Mit der hier vorgestellten Anordnung ist es möglich, ein Bauteil zur Erkennung von Fehlern zu inspizieren. Das Bauteil ist mit der ersten und zweiten Wendeeinrichtung abzulegen, und ein als defekt erkanntes Bauteil an der Ablageposition zu entfernen. Dies erfolgt an einer gemeinsamen Position.

Die Empfangseinrichtung bewegt sich in drei Richtungen: In X-, und Y-Richtung, und um ihre (Z-)Hochachse im / nahe dem Zentrum der Ablageposition. Dies ist auch im Unterschied zu herkömmlichen Anordnungen zu sehen, bei denen das Trägerband in Transportrichtung gefördert wird und die Empfangseinrichtung senkrecht zur Bandtransportrichtung für die Positionierung zur Bauteilablage bewegt wird. Die Ablegestelle kann auch in Gestalt einer Schale (eines Trays, z.B. Jedec-Tray,) oder als Antennenbahn vorliegen.

In einer alternativen Variante ist der Empfangseinrichtung eine Absaug- und/oder Ausblaseinrichtung zugeordnet, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen.

Die Empfangseinrichtung kann in einer Variante Bauteile von einer Wendeeinrichtung empfangen, deren Drehachse im Wesentlichen parallel zur Förderrichtung der Empfangseinrichtung orientiert ist, oder die Empfangseinrichtung kann in einer weiteren Variante Bauteile von einer Wendeeinrichtung empfangen, deren Drehachse im Wesentlichen quer zur Förderrichtung der Empfangseinrichtung orientiert ist.

Im Zentrum der Wendeeinrichtung ist in einer Variante ein bildgebender Eigenschafts- und/oder Lagesensor zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils vorgesehen. Dieser bildgebende Eigenschafts- und/oder Lagesensor ist dazu eingerichtet, zwischen am Umfang der Wendeeinrichtung befindlichen benachbarten Aufnehmern hindurch Bildeinzüge wenigstens einer der Empfangsstellen in der Empfangseinrichtung auszuführen.

In einer alternativen Variante ist im Zentrum der Wendeeinrichtung ein Umlenkspiegel oder Prisma angeordnet, der dem außerhalb der Wendeeinrichtung angeordneten bildgebenden Eigenschafts- und/oder Lagesensor zugeordnet ist, zum Ermitteln von Eigenschaften und/ oder der Lage eines zu empfangenen Bauteils bzw. zum Ermitteln der Lage von Empfangsstellen in der Empfangseinrichtung und/oder darin befindlichen Bauteils. Der Umlenkspiegel oder das Prisma zusammen mit dem außerhalb der Wendeeinrichtung angeordneten bildgebenden Eigenschafts- und/oder Lagesensor sind dazu eingerichtet, zwischen am Umfang der Wendeeinrichtung befindlichen benachbarten Aufnehmern hindurch Bildeinzüge wenigstens einer der Empfangsstellen in der Empfangseinrichtung auszuführen.

Die Empfangseinrichtung ist relativ zu einer Ablagestelle mittels eines Linearantriebes zumindest teilweise längs einer ersten Achse kontrolliert in beide Richtungen zu verfahren. Mittels eines Drehantriebes ist ein durch die Empfangseinrichtung geführter Träger längs einer der ersten und/oder zweiten Achsen kontrolliert in einer Förderrichtung des Trägers zu verfahren. Der durch die Empfangseinrichtung geführte Träger ist mit zwei Empfangsstellen ausgestattet, welche zu einer Ablagestelle für Bauteile durch kontrolliertes Betätigen der Antriebe zumindest annähernd fluchtend auszurichten sind. Ein bildgebender Eigenschafts- und/ oder Lagesensor liefert Eigenschaften und/oder Lage eines in Bezug auf dessen Eigenschaften und/oder seine Lage zu untersuchendes Bauteil in wenigstens einer der Empfangsstellen in der Empfangseinrichtung. Basierend auf Bilddaten aus dem Eigenschafts- und/ oder Lagesensor erfolgen Korrekturanweisungen bei Eigenschafts- und/oder Lagefehlern des Bauteils durch eine Steuerung zur Veranlassung entsprechender Korrekturbewegungen der Empfangseinrichtung und/oder des in ihr geführten Trägers. Der Empfangseinrichtung ist eine Absaug- und/oder Ausblaseinrichtung zugeordnet, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen. In einer anderen Variante verfügt/verfügen der/die im Zentrum der ersten/zweiten Wendeeinrichtung positionierte bildgebende/n Lage- und/oder Eigenschaftssensor/en über eine Reflektoranordnung, welche die indirekte Erfassung der Empfangseinrichtung erlaubt/erlauben, während sich die Wendeeinrichtungen in einer zur Übertragung von Bauteilen vorgesehenen Position (Übertragungsstellung) befinden.

Ein Verfahren zum Entnehmen fehlerhafter Bauteile aus einer Empfangseinrichtung insbesondere der vorstehend beschriebenen Bau-/Funktionweise weist folgende Schritte auf:
Erfassen eines nicht korrekt abgelegten Bauteils in einer Tasche des Trägers für ein Bauteil an der ersten Empfangsstelle,
Bewegen der Empfangseinrichtung mittels eines Linearantriebes längs der Förderrichtung, so dass das nicht korrekt abgelegte Bauteil sich an der zweiten Empfangsstelle befindet, ohne dabei den in der Empfangseinrichtung geführten Träger zu fördern,
Absaugen des nicht korrekt abgelegten Bauteils an der zweiten Empfangsstelle aus der Tasche für ein Bauteil;
Zurückbewegen der Empfangseinrichtung mittels des Linearantriebes entgegen der Förderrichtung, so dass das eine leere Tasche für ein Bauteil sich an der ersten Empfangsstelle befindet, ohne dabei den in der Empfangseinrichtung geführten Träger zu fördern,
Ablegen eines Bauteils in der Tasche des Trägers an der ersten Empfangsstelle.

Aufgrund gestiegener Qualitätsanforderungen bei gleichzeitig sinkenden Abmessungen elektronischer Bauteile, die überdies in stets sinkenden Prozesszeiten zu verarbeiten sind, wurden die herkömmlichen Sensoranordnungen als nicht ausreichend erkannt.

Als eine Variante wird daher ein bildgebender Sensor vorgeschlagen, der geeignet und bestimmt ist zur Erfassung von Lage- und/oder Eigenschaften eines Bauteils, insbesondere in einer Bauteilhandhabungsvorrichtung der vorstehend offenbarten Art. Dieser bildgebende Sensor ist mit wenigstens zwei voneinander abweichenden Erfassungsspektren ausgestattet. Er ist insbesondere geeignet und bestimmt zur Erfassung von Eigenschaftsfehlern und/oder Lagefehlern eines in der Empfangsstelle einer Empfangseinrichtung befindlichen Bauteils. Dieser bildgebende Sensor ist geeignet und bestimmt, mit Strahlungsquellen zusammenzuwirken, die hinsichtlich Strahlungsspektrum und Strahlungsauftreffwinkel und/oder Strahlungsreflexionswinkel relativ zu dem bildgebenden Sensor auf diesen abgestimmt sind. Der bildgebende Sensor ist geeignet und dazu eingerichtet, für jedes seiner Erfassungsspektren einer ihm nachgeordneten Bildauswertung einen separaten Bildeinzug bereitzustellen.

Bei diesem bildgebenden Sensor sind beispielsweise die wenigstens zwei voneinander abweichenden Erfassungsspektren im sichtbaren und nicht sichtbaren Bereich ausgestaltet. Sie können auch als roter Farbbereich - 630nm plus minus 30 nm -, und/ oder grüner Farbbereich - 530 nm plus minus 60 nm -, und/oder blauer Farbbereich - 460nm plus minus 50 nm - eines Farbsensors ausgestaltet sein.

In einer Variante des bildgebenden Sensors sind optisch wirksame Elemente vorgesehen, die dazu eingerichtet sind, den Sensor mit einem Bauteil in wenigstens einer der Empfangsstellen in der Empfangseinrichtung und/oder dem in der Empfangseinrichtung geführten Träger optisch zu koppeln.

In einer Variante des bildgebenden Sensors umfassen die optisch wirksamen Elemente Umlenkspiegel, Prismen, Farbfilter und/oder Linsen.

Einzelne der optisch wirksamen Elemente und/oder der Strahlungsquellen können dazu eingerichtet sein, unabhängig von anderen aktiviert, ausgerichtet und/oder justiert / fokussiert zu werden.

Die hier offenbarte integrierte Handhabungs-/Inspektionseinrichtung verwendet bildgebende Sensoren, die einerseits alle oder fast alle Deck- und/oder Seitenfläche(n) eines Bauteils inspizieren und dabei andererseits auch relevante Daten zur Positionierung der Manipulatoren (Aufnehmer) an der ersten und/oder der zweiten Wendeeinrichtung und der Empfangsstellen liefern.

Der bildgebende Sensor der ersten (oberen) Wendeeinrichtung ist in einer Variante eine Farbkamera im Zentrum der Wendeeinrichtung. Alternativ kann die Kamera auch eine Schwarz/Weiß-Kamera sein, die in einer weiteren Variante seitlich und mit einem 45° - Umlenkspiegel im Zentrum der Wendeeinrichtung zusammenwirkt. In einer Variante erfasst diese Kamera während der Rotation der oberen Wendeeinrichtung durch den Spalt zwischen zwei Aufnehmern das im nächsten Schritt von dem Bauteil-Ausstoßer aus dem Bauteilvorrat vereinzelte Bauteil. Aus dem dabei gewonnenen Bildeinzug ist sowohl eine Inspektion des Bauteils als dessen exakte Positionsbestimmung im Bauteilvorrat möglich. Der Bildeinzug findet während der Rotation der oberen Wendeeinrichtung, in dem als Blickfenster bezeichneten Zeitraum statt. In einer anderen Variante verfügt die im Zentrum der ersten (oberen) Wendeeinrichtung positionierte Kamera über eine Spiegelanordnung, welche die indirekte Erfassung des Bauteil-Ausstoßers erlaubt, während sich die Wendeeinrichtungen in einer zur Übertragung von Bauteilen vorgesehenen Position (Übertragungsstellung) befinden.

Die hier offenbarte integrierte Handhabungs-/Inspektionseinrichtung verwendet außerdem bildgebende Sensoren in Form von seitlichen Kameras an der oberen Wendeeinrichtung. Diese sind etwa bei 90° radial außerhalb der oberen Wendeeinrichtung derart angeordnet, dass das Bauteil auf seinem Flugkreis von einer mittleren Kamera frontal erfasst wird und von den zu beiden Seiten der mittleren Kamera jeweils einander gegenüberliegende Mantelfläche erfasst werden. Diese Kameras sind nicht zwingend Farbkameras. Es können mehrere Bildeinzüge angefertigt werden, weil die obere Wendeeinrichtung kurzzeitig (10ms bis 60 ms, zum Beispiel 40 ms) jeweils wegen der nachfolgenden Bauteilübergabe in der 180° Position still steht. Dieser kurze Stillstandszeitraum ist ausreichend für die Inspektion. Dazu können auch Schwarz/Weiß-Kameras eingesetzt sein. Mit der Seiteninspektion durch die beiden seitlichen Kameras werden die Stirnseiten des Bauteils auf Beschädigungen untersucht. Mit der Rückseiteninspektion durch die mittlere Kamera wird die Bauteilrückseite auf Beschädigungen untersucht. Für die Rückseiteninspektion können mehrere Bildeinzüge durchgeführt werden um verschiedene Defekte hervorzuheben. Bei den hier verwendeten Kameras kann es sich ebenfalls um Farbkameras handeln. Dies ist jedoch nicht zwingend erforderlich, da wie oben bereits erwähnt aufgrund des Stillstandszeitraums ausreichend Zeit zur Verfügung steht.

Die hier offenbarte integrierte Handhabungs-/Inspektionseinrichtung verwendet außerdem bildgebende Sensoren in Form von seitlichen Kameras an der unteren Wendeeinrichtung. Diese sind etwa bei 90° radial außerhalb der unteren Wendeeinrichtung derart angeordnet, dass das Bauteil auf seinem Flugkreis von einer mittleren Kamera frontal erfasst wird und von den zu beiden Seiten der mittleren Kamera befindlichen Kameras jeweils einander gegenüberliegende Mantelflächen erfasst werden. Diese Kameras sind nicht zwingend Farbkameras. Vielmehr können auch Schwarz/Weiß-Kameras eingesetzt sein. An dieser Position wird das Bauteil sowohl auf Fehler hin untersucht, als auch werden die Bilddaten auf Positionsdaten hin ausgewertet. Mit der Seiteninspektion durch die beiden seitlichen Kameras wird das Bauteil an seinen Schnittflächen auf Beschädigungen untersucht. Mit der Rückseiteninspektion durch die mittlere Kamera wird die Bauteilrückseite auf Beschädigungen untersucht. Für die Rückseiteninspektion können mehrere Bildeinzüge durchgeführt werden um verschiedene Defekte hervorzuheben. Für die nachfolgende Ablage des Bauteils in der Empfangseinrichtung können die Positionsdaten (x, y, Verdrehung) des Bauteils mit der Seiteninspektion ermittelt werden. In einer anderen Variante wird hierfür die Rückseiteninspektion verwendet. Diese Informationen werden von der Steuerung verwendet um etwaige Korrekturen durchzuführen. Bei den hier verwendeten Kameras kann es sich ebenfalls um Farbkameras handeln. Dies ist jedoch nicht zwingend erforderlich, da während des Stillstandszeitraums ausreichend Zeit zur Verfügung steht.

Die hier offenbarte integrierte Handhabungs-/Inspektionseinrichtung verwendet des Weiteren bildgebende Sensoren in Form einer Kamera im Zentrum der unteren Wendeeinrichtung. Diese Kamera kann eine Farbkamera mit drei einzelnen Kanälen R, G, B sein. Dabei ist es unerheblich, ob eine 3-Chip Farbkamera oder eine 1-Chip Farbkamera eingesetzt wird. 3-Chip Kameras haben für jede Farbe R, G, B einen separaten Bildsensor, eine 1-Chip Kamera verwendet alternierend aktivierte Filter vor dem Bildsensor. Eine hier einsetzbare Schwarz/Weiß-Kamera hat einen Kanal mit zum Beispiel 255 Grau-Stufen, bei einer Farbkamera hat jeder der drei Kanäle zum Beispiel 255 Intensitäts-Stufen einer Farbe. Wesentlich ist, dass die drei Farbkanäle der Kamera getrennt voneinander ansprechbar/auszulesen sind, oder zumindest eine Aufspaltung der drei Farbkanäle in der Steuerung erfolgen kann. Für jeden Kanal sind unterschiedliche Belichtungszeiten möglich. Hier können zum Beispiel folgende Belichtungszeiten verwendet werden: 5 ms (grün), 12 ms (rot), 15 ms (blau). Entsprechend der jeweils aktivierten Farbkanäle werden bei der hier offenbarten integrierte Handhabungs-/Inspektionseinrichtung auch unterschiedliche Beleuchtungsfarben verwendet. Weißes Licht ist zwar eine Mischung aus allen Farben, so dass mit dieser Beleuchtungsfarbe alle Kanäle gleichzeitig angesprochen werden könnten. Dies findet hier jedoch dezidiert nicht statt, wenn die erzielbare Bildqualität den Anforderungen nicht entspricht.

Dem bildgebenden Sensor ist in einer Variante ein halbdurchlässiger Spiegel zugeordnet, der unter einem Winkel von etwa 45° zur optischen Achse des Kamera-Chips angeordnet ist und dazu dient, farbiges Licht zweier, mehrerer oder beliebig vieler unterschiedlicher Erfassungsspektren aus entsprechenden Lichtquellen optisch einzukoppeln und auf einen Inspektionsbereich zu richten. Dieses auf den Inspektionsbereich, also die Bauteil-Deckfläche oder Seitenfläche und ggf. deren Umgebung in der Tasche, gerichtete Licht wird dort reflektiert und wird von wenigstens einem Kamera-Chip des bildgebenden Sensors erfasst.

Weiterhin ist in einer Variante dem bildgebenden Sensor eine Lichtquelle als Ringlichtquelle um die Inspektionsstelle zugeordnet. Diese Ringlichtquelle liefert Streulicht unter einem Winkel von etwa 5° - 45° in einem dritten Farbbereich. Auch dieses auf den Inspektionsbereich gerichtete Licht wird dort reflektiert und wird von wenigstens einem Kamera-Chip des bildgebenden Sensors erfasst. Das Licht bzw. die verschiedenfarbigen Lichtquellen können beliebig angeordnet sein bzw. auch den gleichen Strahlungswinkel haben.

Die hier offenbarte integrierte Handhabungs-/Inspektionseinrichtung verwendet im Zentrum der unteren Wendeeinrichtung einen Umlenkspiegel zur Einkopplung einer koaxialen Beleuchtung der Empfangseinrichtung. Genauer wird der durch die Empfangseinrichtung geführte Träger in Form eines Ablagebandes mit Ablagetaschen für die Bauteile mit der Kamera erfasst. Durch eine einzige Bildaufnahme erfolgt eine Inspektion auf Fehler, zum Beispiel das schräge Ablegen des Bauteils, so dass es nicht korrekt in seiner Ablagetasche positioniert ist, oder auf Qualitätsmängel. Außerdem werden durch diese einzige Bildaufnahme die Positionsdaten der Ablagetasche des Ablagebandes für das Ablegen des nächsten Bauteils erfasst. Die aus den einzelnen Farbkanälen zu gewinnende Information kann nach zu untersuchenden Aufgabenstellungen beliebig aufgeteilt werden, beispielsweise wie folgt: Bildkanal 1 mit Beleuchtungstyp 1: Position der Ablagetasche des Ablagebandes zur Positionierung des nächsten Bauteils. Bildkanal 2 mit Beleuchtungstyp 2: Qualitätsinspektion des Bauteils (Risse, Lasermarken, Ausbrüche, ...). Bildkanal 3 mit Beleuchtungstyp 3: Zusatzinspektionen für spezielle Bauteile oder kundenspezifische Fehler.

Das Bauteil wird bei einer Variante der integrierten Handhabungs-/Inspektionseinrichtung "blind" abgelegt. Das heißt, dass der eigentliche Ablegevorgang auf Informationen oder Positionsdaten basiert, die vor dem Ablegevorgang aus der Bildaufnahme gewonnen wurde, die dem vorherigen Bauteil zugeordnet ist. Im Moment des Ablegevorgangs sieht die Kamera im Zentrum der zweiten Wendeeinrichtung die Ablegestelle nicht, da der momentan ablegende Aufnehmer die Sicht versperrt.

Informationen oder Positionsdaten, ob ein Bauteil verdreht ist, liefert in einer Variante eine Kamera am Außenumfang der unteren Wendeeinrichtung. Die Informationen oder Positionsdaten werden an die Steuerung der Empfangseinrichtung weitergegeben. Aus der Bildaufnahme des zuvor in der Ablagetasche des Ablagebandes abgelegten Bauteils ist die Position der Empfangseinrichtung bekannt. Der Abstand zwischen den beiden Taschen ist ebenso bekannt. Hieraus kann für das nächste abzulegende Bauteil errechnet werden, um welchen Winkel und x- und y-Betrag die Empfangseinrichtung bewegt werden muss.

Aus den weiteren Vorrichtungsaspekten ergeben sich entsprechende ergänzende oder alternative Verfahrensschritte.

Die hier vorgestellte Anordnung bildgebender Sensorik ist in der Lage, mit weniger Bildeinzügen als herkömmliche Sensoranordnungen auszukommen. Die gewonnenen Bilddaten lassen sich sowohl zur Schlechtteilausschleusung als auch zur Positionierung der Aktoren der Handhabungs-/Inspektionseinrichtung auswerten. Diese integrierte Architektur und die sich damit ermöglichende Vorgehensweise reduziert die Prozesszeit und bietet bei erhöhter Durchsatzzahl eine gesteigerte Inspektionsqualität.

### Kurzbeschreibung der Figuren

Weitere Merkmale, Eigenschaften, Vorteile und mögliche Abwandlungen werden für einen Fachmann anhand der nachstehenden Beschreibung deutlich, in der auf die beigefügten Zeichnungen Bezug genommen ist. Dabei zeigen die Fig. schematisch eine optische Untersuchungseinrichtung für ein Bauteil,
Fig. 1 zeigt schematisch eine Bauteilhandhabungsvorrichtung mit Selbstjustierungsvorrichtung in einer Seitenansicht, wobei die Bauteilhandhabungsvorrichtung eine erste Wendeeinrichtung zum Entnehmen von prismatischen oder zylindrischen Bauteilen von einem strukturierten Bauteilvorrat und zum Ablegen an einer Empfangseinrichtung umfasst.
Fig. 2 zeigt schematisch die Ausrichtung der diversen Lage- und Eigenschaftssensoren der Bauteilhandhabungsvorrichtung aus Fig. 1 in Bezug auf die Seitenflächen eines Bauteils.
Fig. 3 zeigt schematisch einen der am Umfang einer oder beider Wendeeinrichtungen der Bauteilhandhabungsvorrichtung angeordneten Lage- und Eigenschaftssensoren in einer Draufsicht.
Fig. 4 zeigt schematisch eine Empfangseinrichtung zum Einsatz mit der Bauteilhandhabungsvorrichtung in einer perspektivischen Ansicht.
Fig. 5 zeigt schematisch einen der Lage- und Eigenschaftssensoren mit zugeordneter Beleuchtungsanordnung zum Einsatz mit der Bauteilhandhabungsvorrichtung.

### Detaillierte Beschreibung der Figuren

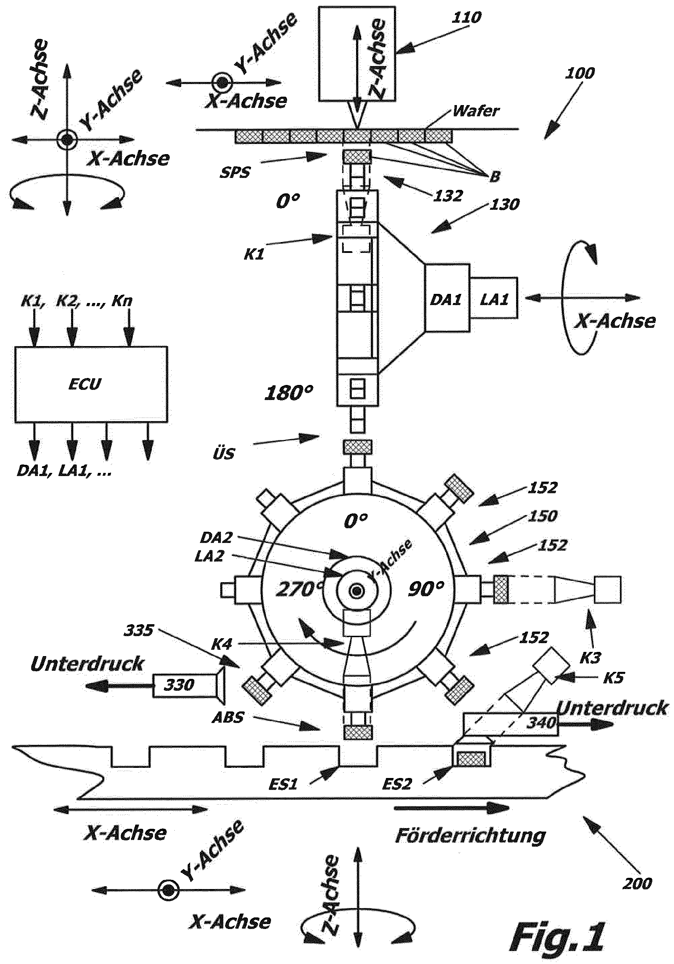

In Fig. 1 ist eine Bauteilhandhabungsvorrichtung 100 zum Entnehmen von prismatischen Bauteilen B in Form elektronischer Halbleiterchips von einem strukturierten Bauteilvorrat und zum Ablegen an einer Empfangseinrichtung 200 veranschaulicht. Die hier vorgestellte Bauteilhandhabungsvorrichtung 100 übernimmt die Bauteile B von einem horizontal im oberen Bereich der Bauteilhandhabungsvorrichtung angeordneten Bauteilvorrat, hier einer Waferscheibe, mit einer ortsfesten Ausstoßeinheit 110.

Die Ausstoßeinheit 110 arbeitet in der gezeigten Variante mit einer durch eine Steuerung ECU kontrollierten Nadel oder sie arbeitet zum Beispiel berührungslos mit einem Laserstrahl, um die Bauteile einzeln von dem Bauteilvorrat freizugeben, damit sie einer ersten Wendeeinrichtung 130 zugeführt werden. Diese erste Wendeeinrichtung 130 hat die Form eines Sterns oder Rades und hat an ihrem Umfang mehrere (im gezeigten Beispiel acht) Aufnehmer 132 für die vereinzelten Bauteile B. Jeder der Aufnehmer 132 ist dazu eingerichtet, wenn er sich bei der 0°-Position der ersten Wendeeinrichtung 130 der Ausstoßeinheit 110 am nächsten befindet, an einer Spendestelle SPS ein Bauteil von dem strukturierten Bauteilvorrat zu empfangen.

Die Aufnehmer 132 sind radial nach außen weisend am (gedachten) Umfang der stern- oder radförmigen ersten Wendeeinrichtung 130 angeordnet und tragen die Bauteile B. Die Aufnehmer 132 der ersten Wendeeinrichtung 130 sind zur Drehachse (hier der X-Achse) radial verfahrbar. Somit können diese Aufnehmer 132 die Bauteile B, jeweils an einem der Aufnehmer 132 fixiert, innerhalb eines Schwenkwinkels - hier zwischen 0° und 180° - zwischen Bauteil-Übernahme und -Übergabe fördern.

Die erste Wendeeinrichtung 130 rotiert das Bauteil B, gesteuert von der nicht weiter veranschaulichten Steuerung ECU um eine erste Achse, hier die X-Achse, zu einer ersten Übergabestelle ÜS um einen ersten vorbestimmten Winkel, hier 180°. Dabei wird das Bauteil B um seine Längs- oder Querachse gewendet. Eine der ersten Wendeeinrichtung 130 ähnliche zweite Wendeeinrichtung 150 mit mehreren, hier ebenfalls acht, zweiten Aufnehmern 152 ist dazu eingerichtet, das Bauteil B an der Übergabestelle ÜS von einem Aufnehmer 132 der ersten Wendeeinrichtung 130 zu empfangen, wenn das Bauteil sich bei der 0°-Position der zweiten Wendeeinrichtung 130 der Übergabestelle ÜS am nächsten befindet.

Die zweite Wendeeinrichtung 150 wendet das empfangene Bauteil B, gesteuert von der Steuerung ECU, um eine zweite Achse, hier die Y-Achse, um einen zweiten vorbestimmten Winkel, hier um etwa 180°, um seine Längs- oder Querachse und fördert es zu einer Ablagestelle ABS.

In einer anderen Variante rotiert die erste Wendeeinrichtung 130 das Bauteil B ebenfalls, gesteuert von der nicht weiter veranschaulichten Steuerung ECU um die erste Achse (hier die X-Achse) um einen ersten vorbestimmten Winkel, hier 180°. Dabei wird das Bauteil B ebenfalls um seine Längs- oder Querachse gewendet, jedoch unmittelbar zu der Ablagestelle ABS gefördert, ohne zuvor auf eine zweite Wendeeinrichtung 150 übertragen zu werden.

Die ersten, zweiten und/oder dritten Achsen schließen miteinander jeweils einen Winkel von 90° plus/minus maximal 10° oder 15° ein und orientieren sich an einem dreidimensionalen orthogonalen Koordinatensystem.

Die beiden stern- oder radförmigen Wendeeinrichtungen 130, 150 sind orthogonal zueinander angeordnet und stimmen ansonsten in ihrem Aufbau überein. Abweichend von der Darstellung in Fig. 1 kann die Anordnung der beiden Wendeeinrichtungen 130, 150 relativ zur Förderrichtung der Empfangseinrichtung 200 auch um die Z-Achse um 90° gedreht sein. In diesem Fall ist die untere Wendeeinrichtung 150 zumindest annähernd quer zur Förderrichtung der Empfangseinrichtung 200 orientiert.

Den ersten und zweiten Wendeeinrichtungen 130, 150 sind Lage- und Eigenschaftssensoren K1 ... K4, K7... K11 zugeordnet. Wie in Fig. 1 gezeigt, befinden sich diese Sensoren an mehreren Stellen der Gesamtanordnung. Sie sind dazu eingerichtet, Lagedaten der ersten und zweiten Wendeeinrichtungen 130, 150, Lagedaten von an den Aufnehmern 132, 152 befindlichen Bauteilen B, sowie Eigenschaften von an den Aufnehmern 132, 152 befindlichen Bauteilen B zu erfassen. Die dabei gewonnenen Daten werden einer Steuerung zur Verfügung gestellt. In der hier veranschaulichten Ausführung ist eine erste Kameraanordnung K1 im Zentrum der ersten Wendeeinrichtung 130 senkrecht nach oben auf den Bauteilvorrat gerichtet. Kameraanordnung K1 umfasst hierbei eine Kamera und zwei rechtwinklig zueinander angeordnete Spiegel, welche jeweils in einem 45° Winkel relativ zur durch die X- und Y-Achse aufgespannten Ebene angebracht sind. Diese Spiegel erlauben es, die Spendestelle SPS und die Ausstoßeinheit 110 und den an der Spendestelle SPS befindlichen Aufnehmer 132 indirekt aus einer ersten und einer zweiten Erfassungsrichtung zu erfassen. Die Spiegel sind hierbei so angeordnet, dass die zwei Erfassungsrichtungen orthogonal zueinander verlaufen.

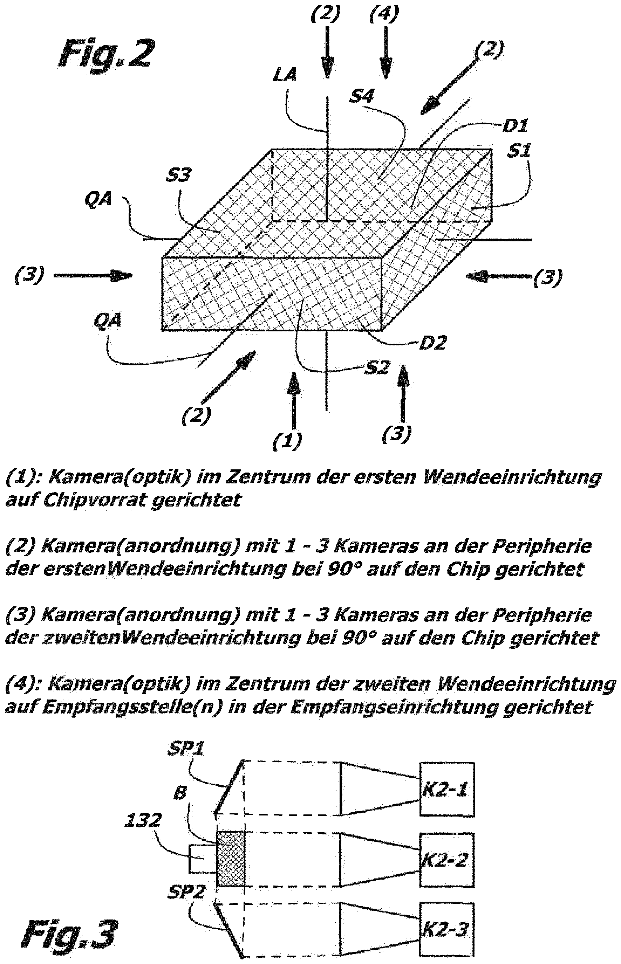

Eine zweite Kameraanordnung K2 mit drei Kameras - in Fig. 1 nicht zu sehen - ist an der Peripherie der ersten Wendeeinrichtung 130 bei 90° auf das daran vorbeigeführte Bauteil B gerichtet. Details zu dieser zweiten Kameraanordnung K2 werden im Zusammenhang mit Fig. 3 erläutert. Eine der zweiten Kameraanordnung K2 entsprechende dritte Kameraanordnung K3 mit drei Kameras ist an der Peripherie der zweiten Wendeeinrichtung 150 bei 90° auf das daran vorbeigeführte Bauteil B gerichtet. Die Kameraanordnung K2 und K3 eignen sich jeweils auch dazu, eine Positionsbweichung des vorbeigeführten Aufnehmers 132, 152 zu einem zuvor definierten Referenzpunkt zu bestimmen.

Eine vierte Kameraanordnung K4 ist im Zentrum der zweiten Wendeeinrichtung 150 auf die Ablagestelle ABS oder die erste Empfangsstelle ES1 in der Empfangseinrichtung 200 gerichtet. Kameraanordnung K4 umfasst hierbei eine Kamera und zwei rechtwinklig zueinander angeordnete Spiegel, welche jeweils in einem 45° Winkel relativ zur durch die X- und Y-Achse aufgespannten Ebene angebracht sind. Diese Spiegel erlauben es, die Ablagestelle ABS und die Empfangsstelle ES1 und den an der Ablagestelle ABS befindlichen Aufnehmer 152 indirekt aus einer ersten und einer zweiten Erfassungsrichtung zu erfassen. Die Spiegel sind hierbei so angeordnet, dass die zwei Erfassungsrichtungen orthogonal zueinander verlaufen.

Eine siebte Kameraanordnung K7 im Zentrum der ersten Wendeeinrichtung 130 ist auf die Übergabestelle ÜS und die Aufnehmer 132 und 152 der ersten und zweiten Wendeeinrichtung gerichtet. Kameraanordnung K7 umfasst hierbei eine Kamera und zwei rechtwinklig zueinander angeordnete Spiegel, welche jeweils in einem 45° Winkel relativ zur durch die X- und Y-Achse aufgespannten Ebene angebracht sind. Diese Spiegel erlauben es, die Übergabestelle ÜS und die an der Übergabestelle befindlichen Aufnehmer 132,152 indirekt aus einer ersten und einer zweiten Erfassungsrichtung zu erfassen. Die Spiegel sind hierbei so angeordnet, dass die zwei Erfassungsrichtungen orthogonal zueinander verlaufen.

In jener Variante, in der die Bauteile von der ersten Wendeeinrichtung 130 auf die Empfangseinrichtung 200 übergeben werden, ersetzt die Kameraanordnung K7 funktional die baugleiche Kameraanordnung K4.

In jener Variante, in der die Bauteile B von der ersten Wendeeinrichtung 130 direkt auf die Empfangsstelle ES1 übergeben werden, ist die Kameraanordnung K7 im Zentrum der ersten Wendeeinrichtung 130 auf die Ablagestelle ABS und die erste Empfangsstelle ES1 in der Empfangseinrichtung 200 gerichtet. Die Spiegel der Kameraanordnung sind hierbei so angeordnet, dass eine Erfassung der Empfangsstelle ES1 in der Empfangseinrichtung 200 aus zwei zueinander orthogonalen Erfassungsrichtungen erlaubt wird.

Eine elfte Kameraanordnung K11 im Zentrum der zweiten Wendeeinrichtung 150 ist auf die Übergabestelle ÜS und die Aufnehmer 132 und 152 der ersten und zweiten Wendeeinrichtung gerichtet. Kameraanordnung K11 umfasst hierbei eine Kamera und zwei rechtwinklig zueinander angeordnete Spiegel, welche jeweils in einem 45° Winkel relativ zur durch die X- und Y-Achse aufgespannten Ebene angebracht sind. Diese Spiegel erlauben es, die Übergabestelle und die den an der Übergabestelle ÜS befindlichen Aufnehmer 132, 152 indirekt aus einer ersten und einer zweiten Erfassungsrichtung zu erfassen. Die Spiegel sind hierbei so angeordnet, dass die zwei Erfassungsrichtungen orthogonal zueinander verlaufen.

Die Steuerung ECU ist dazu eingerichtet, mittels eines ersten Drehantriebes DA1 die erste Wendeeinrichtung 130 um eine erste Achse (hier die X-Achse) kontrolliert zu drehen und mittels eines ersten Linearantriebes LA1 die erste Wendeeinrichtung 130 längs der ersten Achse kontrolliert zu verfahren.

Die Steuerung ECU ist weiterhin dazu eingerichtet, mittels eines zweiten Drehantriebes DA2 die zweite Wendeeinrichtung 150 um eine zu der ersten Achse (hier die X-Achse) nicht kollineare zweite Achse (hier die Y-Achse) kontrolliert zu drehen, und mittels eines zweiten Linearantriebes LA2 die zweite Wendeeinrichtung 150 längs der zweiten Achse kontrolliert zu verfahren.

Die bildgebenden Sensoren inspizieren die Deck- und/oder Seitenfläche(n) des Bauteils B und liefern dabei auch relevante Daten zur Positionierung der ersten und zweiten Wendeeinrichtungen 130, 150 längs und um deren Achsen, sowie der Aufnehmer 132, 152 und der an ihnen befindlichen Bauteile B und der Empfangsstellen. Die Daten zur Positionierung der ersten und zweiten Wendeeinrichtung 130, 150 und der Aufnehmer 132, 152 können insbesondere auch während der Selbstjustierung der Vorrichtung Verwendung finden.

Eine Kameraanordnung K8 mit zwei Kameras - in Fig. 1 nur eine zu sehen - ist an der Peripherie der ersten, zweiten Wendeeinrichtung 130,150 aus zwei verschiedenen Erfassungsrichtungen auf die Spendestelle SPS gerichtet. Die Kameras sind jeweils um 90°, plus/minus maximal 10° oder 15° versetzt, in einer durch die X- und Y-Achse aufgespannte Ebene zueinander angeordnet und so auf die Spendestelle SPS gerichtet, dass sie sowohl die Ausstoßeinheit 110 wie auch den Aufnehmer 132 zumindest in Teilen erfassen. Die Kameraanordnung K8 kann aufgrund der (zu diesem Zweck notwendigerweise) im Wesentlichen rechtwinkligen Anordnung der beiden Einzelkameras eine Position des Aufnehmers 132 relativ zur Ausstoßeinheit 110 entlang der X-, der Y- und der Z-Achse bestimmen.

Eine Kameraanordnung K9 mit zwei Kameras - in Fig. 1 nur eine zu sehen - ist an der Peripherie der ersten/zweiten Wendeeinrichtung 130,150 aus zwei verschiedenen Erfassungsrichtungen auf die Ablagestelle ABS gerichtet. Die Kameras sind jeweils um 90°, plus/minus maximal 10° oder 15° versetzt, in einer durch die X- und Y-Achse aufgespannte Ebene zueinander angeordnet und so auf die Ablagestelle ABS gerichtet, dass sie sowohl den Aufnehmer 132, 152 wie auch die Empfangsstelle ES1 zumindest in Teilen erfassen. Die Kameraanordnung K9 kann aufgrund der (zu diesem Zweck notwendigerweise) im Wesentlichen rechtwinkligen Anordnung der beiden Einzelkameras eine Positionsabweichung der Empfangsstelle ES1 zu dem Aufnehmer 132, 152 entlang der X-, der Y- und der Z-Achse bestimmen.

Eine Kameraanordnung K10 mit zwei Kameras - in Fig. 1 nur eine zu sehen - ist an der Peripherie ersten/zweiten Wendeeinrichtung 130,150 aus zwei verschiedenen Erfassungsrichtungen auf die Übergabestelle ÜS gerichtet. Die Kameras sind jeweils um 90°, plus/minus maximal 10° oder 15° versetzt, in einer durch die X- und Y-Achse aufgespannte Ebene zueinander angeordnet und so auf die Übergabestelle ÜS gerichtet, dass sie sowohl den Aufnehmer 132 wie Aufnehmer 152 zumindest in Teilen erfassen. Die Kameraanordnung K10 kann aufgrund der (zu diesem Zweck notwendigerweise) im Wesentlichen rechtwinkligen Anordnung der beiden Einzelkameras eine Positionsabweichung des Aufnehmers 152 zu dem Aufnehmer 132 entlang der X-, der Y- und der Z-Achse bestimmen.

Die Bauteilhandhabungsvorrichtung 100 ist mit einer der Ablagestelle ABS zugeordneten Empfangseinrichtung 200 für ein dorthin gefördertes Bauteil B ausgestattet. Der Empfangseinrichtung 200 sind dabei Lage- und Eigenschaftssensoren K4/K7, K5 zugeordnet, die dazu eingerichtet sind, Lagedaten des an die Ablagestelle ABS geförderten Bauteils B, Lagedaten und Eigenschaften von Empfangsstellen ES1, ES2 in der Empfangseinrichtung 200 und der darin befindlichen Bauteile B zu erfassen und für eine Steuerung ECU zur Verfügung zu stellen. Dabei ist der Lage- und Eigenschaftssensor K5 eine fünfte Kameraanordnung, die auf ein zweites Fenster an der zweiten Empfangsstelle ES2 gerichtet ist. Die Steuerung ECU ist dazu eingerichtet, mittels eines dritten Drehantriebes DA3 die Empfangseinrichtung 200 um eine die Ablagestelle ABS enthaltende dritte Achse (hier die Z-Achse) kontrolliert zu drehen und mittels eines dritten und eines vierten Linearantriebes LA3, LA4 die Empfangseinrichtung längs der ersten und der zweiten Achsen kontrolliert zu verfahren. Mittels eines vierten Drehantriebes DA4 verfährt die Steuerung ECU einen durch die Empfangseinrichtung 200 geführten Träger 320 längs der ersten Achse (hier die X-Achse) kontrolliert. Dieser Träger 320 dient dazu, die Bauteile B in vereinzelter Form von der Wendeeinrichtung 130,150 aufzunehmen. Die Wendeeinrichtungen 130, 150 und die Drehantriebe DA1, DA2, ... haben jeweils einen mit der Steuerung ECU verbundenen, nicht weiter dargestellten hochauflösenden rotatorischen Winkel-Encoder zur Bestimmung ihrer jeweiligen Rotationsstellung.

In der Empfangseinrichtung 200 dient der vierte Drehantrieb DA4 dazu, durch Steuersignale aus der Steuerung ECU angesteuert, den durch die Empfangseinrichtung 200 geführten Träger 320 längs der ersten Achse (hier der X-Achse) kontrolliert um etwa 100% plus minus maximal 3% des Rastermaßes benachbarter Bauteil-Aufnahmen (Taschen) des Trägers 320 zu verfahren. Das Rastermaß ergibt sich aus dem Mittenabstand zweier aufeinander folgender Taschen. Der dritte Drehantrieb DA3 ist dazu eingerichtet, durch Steuersignale aus der Steuerung ECU angesteuert, in Abhängigkeit von Signalen aus dem bildgebenden Eigenschafts- und Lagesensor im Zentrum der zweiten Wendeeinrichtung 150, oder in einer Variante der bildgebende Eigenschafts- und Lagesensor im Zentrum der ersten Wendeeinrichtung 130,eine der Empfangsstellen ES1 mit der dort befindlichen Bauteil-Aufnahme des Trägers 320 um die die Ablagestelle enthaltende Z-Achse kontrolliert um bis zu plus minus 6 ° zu drehen.

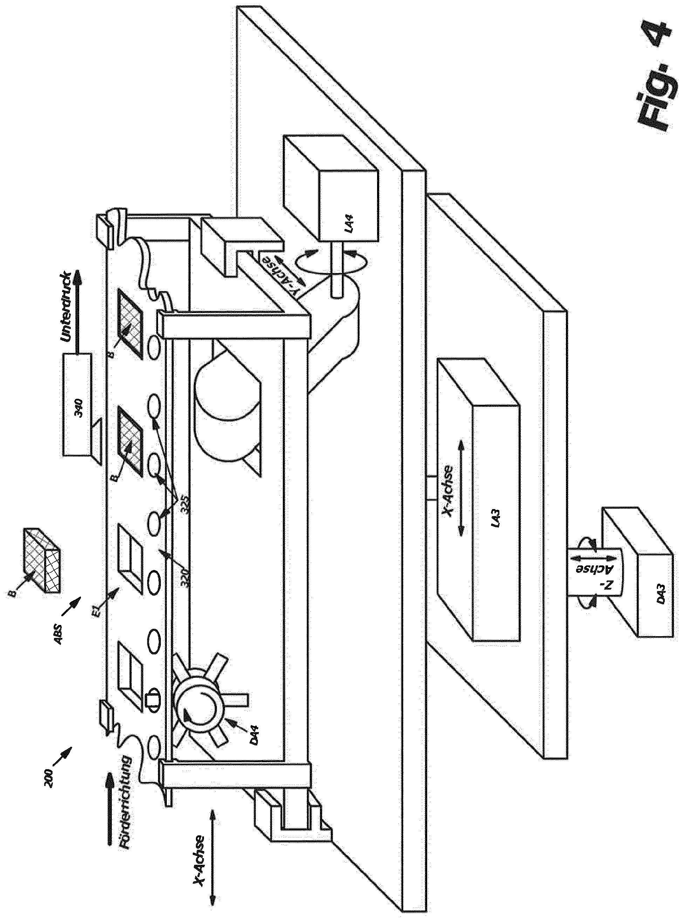

Der vierte Drehantrieb DA4 der Empfangseinrichtung 200 hat in der in Fig. 4 gezeigten Varianten ein Stachelrad, das in Transportlöcher 325 des Trägers 320 (Ablagebandes) eingreift um es in Förderrichtung zu transportieren. Das Stachelrad dreht dabei bevorzugt nur in eine Vorwärts-Richtung.

Bei der Empfangseinrichtung 200 ist in dieser Variante eine Absaug- und/oder Ausblaseinrichtung 340 abstromseitig zur Empfangsstelle ES1 vorgesehen. Diese ist jedoch optional. Damit werden, durch Steuersignale aus der Steuerung ECU angesteuert, als schadhaft oder fehlerhaft platziert erkannte Bauteile B aus ihrer Tasche entfernt.

Zum Ansaugen des Bauteils B in den Aufnehmern 132, 152, zum Halten des Bauteils B in den Aufnehmern 132, 152, zum Ablegen des Bauteils B mit oder ohne gesteuertem Abblas-Impuls, und zum freien Abblasen des Bauteils B aus den Aufnehmern 132, 152 sind diese mit einer nicht weiter veranschaulichten Pneumatikeinheit verbunden. Die Pneumatikeinheit beaufschlagt, von der Steuerung ECU kontrolliert, die einzelnen Aufnehmer 132, 152 ventilgesteuert zum jeweils erforderlichen Zeitpunkt oder Zeitraum mit Über- oder Unterdruck um die Bauteile B einzeln aufzunehmen, zu halten und wieder abzugeben.

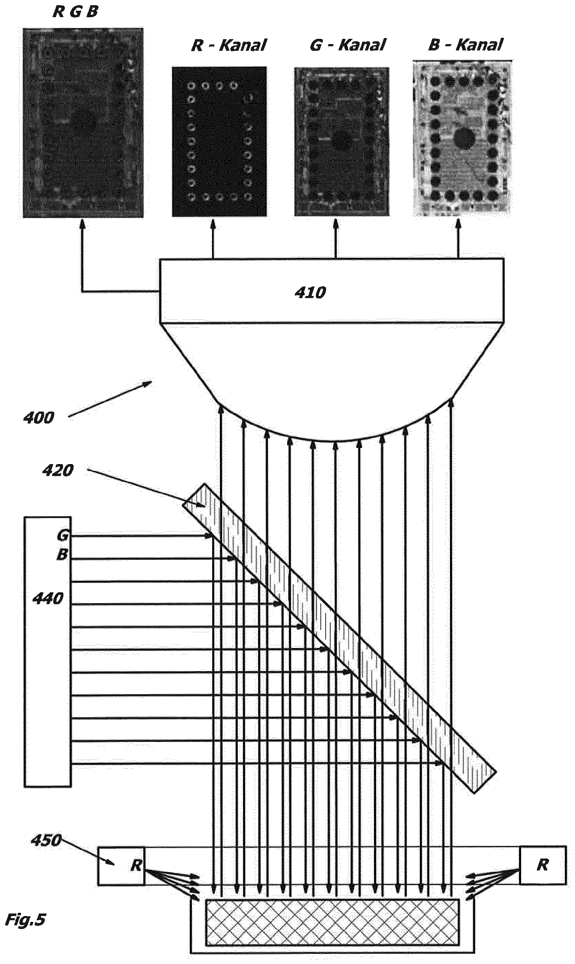

Sofern die mittels der Steuerung ECU und den Lage- und Eigenschaftssensoren an den einzelnen Stationen gewonnenen Inspektionsergebnisse positiv sind, wird das jeweilige Bauteil B in die momentan an der Ablegestelle ABS befindliche Empfangsstelle ES1, also die Tasche des Trägers 320 abgelegt. Sofern die gewonnenen Inspektionsergebnisse negativ sind, wird das Bauteil B um eine weitere Position zu einem ersten Absauger 330 weiter rotiert, wo es von seinem Aufnehmer 132,152 an der ersten oder zweiten Wendeeinrichtung 130,150 abgesogen wird. Sofern sich durch einen diese Empfangsstelle ES1 überwachenden Lage- und Eigenschaftssensor (siehe auch Fig. 5) ergibt, dass das abgelegte Bauteil B nach der Ablage einen Lage- oder Eigenschaftsfehler hat, wird es mittels eines abstromseitig zur Empfangsstelle ES1 befindlichen zweiten Absaugers 340 aus der Tasche des Trägers 320 herausgesaugt. Anschließend wird in diesem Fall, von der Steuerung ECU kontrolliert, die gesamte Empfangseinrichtung 200 zusammen mit dem Träger 320 um den Mittenabstand zweier Taschen des Trägers 320 mit der dritten Linearantriebseinheit LA3 entgegen der Förderrichtung des Trägers 320 zurückgesetzt. Dann wird das nächste Bauteil B an der Wendeeinrichtung 130, 150 in die freigewordene Tasche des Trägers 320 eingebracht.

Bei einer weiteren Variante ist der ersten Empfangsstelle ES1 eine zusätzliche, nicht weiter veranschaulichte Absaugeinrichtung zugeordnet, um ein schräg liegendes Bauteil an der Empfangsstelle ES1 abzusaugen. Durch den Lage- und Eigenschaftssensor K4/K7 oder durch den Lage- und Eigenschaftssensor K5 am zweiten Fenster können etwaige Qualitätsfehler festgestellt werden. Sofern der Lage- und Eigenschaftssensor K5 einen Qualitätsfehler erfasst, wird die Empfangseinrichtung 200 zusammen mit dem Träger 320 zurücktransportiert, an der Ablagestelle wird dann das Bauteil B aus der Tasche des Trägers 320 abgesaugt. Eine Verkippung eines schräg liegenden Bauteils an der Empfangsstelle ES1 kann durch einen nicht weiter dargestellten Lage- und Eigenschaftssensor K6 erkannt werden, welcher der Empfangsstelle ES1 zugeordnet ist. Dieser Lage- und Eigenschaftssensor K6 ist seitlich zum Träger 320 angeordnet und erfasst die Empfangsstelle ES1 direkt oder über einen Umlenkspiegel über die Oberkante des Trägers 320. So kann eine etwaige Verkippung oder ein Überstand eines nicht korrekt abgelegten Bauteils erkannt werden.

Wie in der Fig. 2 in Verbindung mit der Fig. 1 veranschaulicht ist, ist die Kameraanordnung K1 in einer Variante als Lage- und Eigenschaftssensor im Zentrum der ersten Wendeeinrichtung 130 auf den Bauteilvorrat gerichtet. Damit wird die Deckfläche D2 des Bauteils B auf Lage und Fehler inspiziert. Dabei ist die Kameraanordnung K1 in dieser Variante dazu eingerichtet, einen Bildeinzug jeweils während der Wendebewegung der ersten Wendeeinrichtung 130 zwischen zwei benachbarten Aufnehmern 132 hindurch auszuführen. Die Steuerung erzeugt aus diesen Bilddaten entsprechende Korrekturbewegungen der Ausstoßeinheit, des Bauteilvorrats bzw. des Wafers und der ersten Wendeeinrichtung 130.

Die zweite Kameraanordnung K2 ist als Lage- und Eigenschaftssensor mit ihren drei Kameras an der Peripherie der ersten Wendeeinrichtung 130 bei etwa 90° auf die drei Seiten S2, S4 und D1 des Bauteils B gerichtet. Eine Draufsicht auf die Kameraanordnung K2 mit ihren drei Kameras K2-1, K2-2 und K2-3 ist in Fig. 3 veranschaulicht. Hierbei inspiziert die mittlere Kamera K2-2 die Deckfläche D1 des Bauteils B und die beiden äußeren Kamera K2-1 und K2-3 über jeweilige Spiegel SP1 und SP2 die Seitenflächen S2 und S4 des Bauteils B. Aus den dabei erfassten Bildeinzügen lässt sich neben etwaigen Fehlern des Bauteils B an diesen Flächen auch die genaue Lage und Rotation des Bauteils B an seinem Aufnehmer 132 bestimmen. Diese Information wird in der Steuerung ECU dazu verwendet, die Ausrichtung der ersten Wendeeinrichtung 130 sowie der zweiten Wendeeinrichtung 150 längs ihrer Achsen und Rotationsorientierung zu verändern, wenn das inspizierte Bauteil B an der Übergabestelle ÜS von der ersten Wendeeinrichtung 130 zu der zweiten Wendeeinrichtung 150 übergeben wird. Darüber hinaus eignet sich die zweite Kameraanordnung K2 dazu, die Abweichung eines jeden Aufnehmers 132 der ersten Wendeeinrichtung 130 zu einem zuvor definierten gemeinsamen Referenzpunkt zu ermitteln.

Die dritte Kameraanordnung K3 ist als Lage- und Eigenschaftssensor mit ihren drei Kameras extern an der Peripherie der zweiten Wendeeinrichtung 150 bei etwa 90° auf die drei Seiten S1, S3 und D2 des Bauteils B gerichtet. Diese Kameraanordnung K3 entspricht in ihrem Aufbau und ihrer Anordnung der Kameraanordnung K2 mit ihren drei Kameras und beiden Spiegeln in Fig. 3. Aus den dabei erfassten Bildeinzügen lässt sich neben etwaigen Fehlern des Bauteils B an diesen Flächen auch die genaue Lage und Rotation des Bauteils B an seinem Aufnehmer 152 der zweiten Wendeeinrichtung 150 bestimmen. Diese Information wird in der Steuerung ECU dazu verwendet, die Ausrichtung der zweiten Wendeeinrichtung 150 sowie der Empfangseinrichtung 200 längs ihrer Achsen und Rotationsorientierungen zu verändern, wenn das inspizierte Bauteil B an der Übergabestelle ÜS von der zweiten Wendeeinrichtung 150 in die an der Ablegestelle ABS befindliche Empfangsstelle ES1, also die Tasche des Trägers 320 abgelegt wird. Darüber hinaus eignet sich die dritte Kameraanordnung K3 dazu, die Abweichung eines jeden Aufnehmers 152 der zweiten Wendeeinrichtung 150 zu einem zuvor definierten gemeinsamen Referenzpunkt zu ermitteln.

Die vierte Kameraanordnung K4 ist als Lage- und Eigenschaftssensor im Zentrum der zweiten Wendeeinrichtung 150 auf die Empfangsstelle E1 in der Empfangseinrichtung 200 gerichtet. Die Steuerung ECU veranlasst dann entsprechende Korrekturbewegungen der zweiten Wendeeinrichtung 150 und der Empfangseinrichtung 200.

Weiter ist die Kameraanordnung K4 dazu eingerichtet, sowohl die Empfangsstelle ES1 als auch den an der Ablagestelle ABS befindlichen Aufnehmer 152 gleichzeitig mit Hilfe einer Spiegeloptik aus verschiedenen Erfassungsrichtung zu erfassen, sodass ein eine relative Position der Empfangsstelle ES1 zum Aufnehmer 152 durch die Steuerung zur Selbstjustierung der Bauteilhandhabungsvorrichtung 100 bestimmt werden kann.

Die in Fig. 1 gezeigte Bauteilhandhabungsvorrichtung 100 beinhaltet eine Steuerung, welche das selbständige Justieren der Bauteilhandhabungsvorrichtung 100 steuert.

Eine Selbstjustierung ist insbesondere vor Inbetriebnahme der Bauteilhandhabungsvorrichtung 100 aber auch während des Betriebs der Bauteilhandhabungsvorrichtung 100 möglich.

Beliebige Kombinationen der Kameraanordnungen K1, K4, K7, K9, K9, K10 und K11 zur Selbstjustierung der Bauteilhandhabungsvorrichtung 100 sind möglich, wenn mindestens ein auf die Spendestelle SPS gerichteter Sensor, mindestens ein auf die Übergabestelle ÜS gerichteter Sensor und mindestens ein auf die Ablagestelle ABS gerichteter Sensor am Selbstjustierungsverfahren beteiligt sind.

In jener Variante, in der die Bauteile von der ersten Wendeeinrichtung 130 auf die Empfangseinrichtung 200 übergeben werden, genügen zwei Kameraanordnungen zur Selbstjustierung der Bauteilhandhabungsvorrichtung 100, sofern mindestens ein auf die Spendestelle SPS gerichteter Sensor und mindestens ein auf die Ablagestelle ABS gerichteter Sensor am Selbstjustierungsverfahren beteiligt sind.

Die Steuerung ist dazu eingerichtet, während des Selbstjustierungsverfahrens die erste Wendeeinrichtung 130 sukzessive zu rotieren und mit den Kamerasensoren K1 und/oder K8 eine relative Position eines jeden einzelnen Aufnehmers 132 der ersten Wendeeinrichtung 130 zur Ausstoßeinheit 110 zu ermitteln. Mit den Kamerasensoren K7 und/oder K10 und/oder K11 wird die Position des an der Übergabestelle ÜS befindlichen Aufnehmers 152 der zweiten Wendeeinrichtung 150 in Relation zu dem an der Übergabestelle befindlichen Aufnehmer 132 der ersten Wendeeinrichtung 130 ermittelt. Mit den Kamerasensoren K9 und/oder K4/K7 (K4 in der Variante mit zwei Wendeeinrichtungen 130,150 und K7 in der Variante mit einer Wendeeinrichtung 130) wird die Position der in der Empfangseinrichtung 200 befindlichen Empfangsstelle ES1 zu dem an der Ablagestelle ABS befindlichen Aufnehmer 132,152 der ersten/zweiten Wendeeinrichtung 130,150 ermittelt.

In der Variante mit nur einer ersten Wendeeinrichtung 132 werden nur die relativen Positionen an der Spendestelle SPS und der Ablagestelle ABS ermittelt.

Die Steuerung ist hierbei dazu eingerichtet, das sukzessive Rotieren der Wendeeinrichtungen 130,150 und das ermitteln der relativen Position mindestens so oft zu wiederholen, bis alle möglichen Übertragungsstellung der Wendeeinrichtung 130,150 an der Spendestelle SPS, der Übergabestelle ÜS und der Abgabestelle ABS mindestens einmal erreicht wurden. Die Steuerung ist hierbei weiter dazu eingerichtet, die ermittelten Werte in einer Steuerungstabelle zu speichern.

Die ermittelten 3-dimensionalen Positionsabweichungen der Aufnehmer 132 der ersten Wendeeinrichtung 130 relativ zu einer zuvor definierten Position zu der Ausstoßeinrichtung 110 bilden im Betrieb jeweils den 3-dimensionalen Korrekturvektor für die erste Wendeeinrichtung 130 für die jeweilige Übertragungsstellung.

Die ermittelten 3-dimensionalen Positionsabweichungen des an der Übergabestelle ÜS befindlichen Aufnehmers 152 der zweiten Wendeeinrichtung 150 relativ zu einer zuvor definierten Position zu dem Aufnehmer 132 der ersten Wendeeinrichtung 130 bilden, addiert mit dem 3-dimensionalen Korrekturvektor für die erste Wendeeinrichtung 130 für die jeweilige Übertragungsstellung, im Betrieb jeweils den 3-dimensionalen Korrekturvektor für die zweite Wendeeinrichtung 150 für die jeweilige Übertragungsstellung.

Die ermittelten 3-dimensionalen Positionsabweichungen der Empfangsstellen ES1 relativ zu einer definierten Position zu dem an der Ablagestelle ABS befindlichen Aufnehmer 152 der zweiten Wendeeinrichtung 150 bilden, addiert mit dem 3-dimensionalen Korrekturvektor für die zweite Wendeeinrichtung 150 für die jeweilige Übertragungsstellung, im Betrieb jeweils den 3-dimensionalen Korrekturvektor für die Empfangseinrichtung 200 für die jeweilige Übertragungsstellung.

In jener Variante, in der die Bauteilhandhabungsvorrichtung 100 nur über eine erste Wendeeinrichtung 130 verfügt, wird der 3-dimensionale Korrekturvektor für die Empfangseinrichtung 200 analog mit den Positionen der Empfangsstellen ES1 relativ zu einer definierten Position zu dem Aufnehmer 132 der ersten Wendeeinrichtung 130 und durch die Addition mit dem 3-dimensionalen Korrekturvektor für die erste Wendeeinrichtung 130 entwickelt.

Eine Erhöhung der Korrekturvektorpräzision erfolgt, wenn eine Mehrzahl von vollständigen Rotationen der Wendeeinrichtungen 130, 150 durchgeführt werden und jeweils Mittelwerte für die Korrekturvektoren ermittelt werden.

Der Korrekturvektor kann in anderen Varianten der Bauteilhandhabungsvorrichtung 100 2-dimensional oder 1-dimensional sein, wobei die Korrekturdimensionen für die erste Wendeeinrichtung 130, die zweite Wendeeinrichtung 150 und die Empfangseinrichtung 200 gleich oder verschieden sein können.

Eine erste Kontrolle der Erfassungsqualität der zur Selbstjustierung verwendeten Kamerasensoren erfolgt, indem das Selbstjustierungsverfahren unabhängig voneinander mit K1, K4 und K7 oder K11 und/oder K8 durchgeführt wird und anschließend mit K2 durchgeführt wird; des Weiteren kann das Selbstjustierungsverfahren mit K7, und/ oder K10 durchgeführt werden. Stimmen die Ergebnisse nicht überein, liegt ein Messfehler vor. So erfolgt ein Prüfen der Erfassungsqualität der Justierungssensoranordnung und/oder ein Prüfen des Aufnehmers 132 auf Beschädigung anhand der Vergleiche.

In anderen Varianten sind beliebige Kombinationen der Kamerasensoren K1, K4, K7, K8, K9, K10 und K11 für die voneinander unabhängigen Selbstjustierungen möglich, sofern keiner der Sensoren in beiden Selbstjustierungen Verwendung findet und in beiden Selbstjustierungen jeweils mindestens ein Sensor auf die Spendestelle SPS, die Übergabestelle ÜS und die Ablagestelle ABS gerichtet ist.

Eine zweite Kontrolle der Erfassungsqualität der zur Selbstjustierung verwendeten Kamerasensoren und eine zusätzliche Überprüfung der Beschädigungsfreiheit der Aufnehmer 132, 152 erfolgt, indem die durch die Kameraanordnungen K2 und K3 ermittelten relativen Positionen der Aufnehmer 132, 152 zu den jeweiligen definierten Referenzpunkten mit den relativen Positionen der Aufnehmer 132, 152 zueinander, zur Ausstoßeinheit 110 und zur Empfangsstelle ES1 für jeden Aufnehmer 132, 152 jeweils durch die Steuerung verglichen werden. Stimmen die ermittelten Abweichungen nicht - zumindest - in ihren jeweiligen Relationen zueinander überein, liegt ein Messfehler vor und/oder einer der Aufnehmer 132, 152 ist beschädigt.

In jener Variante, in der die Bauteilhandhabungsvorrichtung 100 nur über eine erste Wendeeinrichtung 130 verfügt, erfolgt die erste Kontrolle der Erfassungsqualität der Selbstjustierung, indem die Selbstjustierung voneinander unabhängig mit den Kamerasensoren K1 und K7 sowie K8 und K9 durchgeführt wird. Stimmen die Ergebnisse nicht überein, liegt ein Messfehler vor. Beliebige Kombinationen der Kamerasensoren K1, K7, K8, K9, für die voneinander unabhängigen Selbstjustierungen sind möglich, sofern keiner der Sensoren in beiden Selbstjustierungen Verwendung findet und in beiden Selbstjustierungen jeweils mindestens ein Sensor auf die Spendestelle SPS und die Ablagestelle ABS gerichtet ist.

In jener Variante, in der die Bauteilhandhabungsvorrichtung 100 nur über eine erste Wendeeinrichtung 130 verfügt, erfolgt die zweite Kontrolle der Erfassungsqualität und die zusätzliche Überprüfung der Beschädigungsfreiheit der Aufnehmer 132 der Selbstjustierung, indem die durch die Kameraanordnungen K2 ermittelten relativen Positionen der Aufnehmer 132 zu den jeweiligen definierten Referenzpunkten mit den relativen Positionen der Aufnehmer 132 zur Ausstoßeinheit 110 und zur Empfangsstelle ES1 für jeden Aufnehmer 132 jeweils durch die Steuerung verglichen werden. Stimmen die ermittelten Abweichungen nicht - zumindest - in ihren jeweiligen Relationen zueinander überein, liegt ein Messfehler vor und/oder einer der Aufnehmer 132 ist beschädigt.

Der in Fig. 5 veranschaulichte Lage- und Eigenschaftssensor 400 ist als bildgebender Sensor eine Variante der Kameraanordnungen K1 - K5. Dieser Sensor 400 hat einen das sichtbare Lichtspektrum aufnehmenden Kamera-Chip 410. Bei diesem bildgebenden Sensor 400 sind die drei voneinander abweichenden Erfassungsspektren als roter Farbbereich - 630nm plus minus 30 nm -, als grüner Farbbereich - 530 nm plus minus 60 nm -, und als blauer Farbbereich - 460nm plus minus 50 nm - eines Farbsensors ausgestaltet.

Dem bildgebenden Sensor 400 ist ein halbdurchlässiger Spiegel 420 zugeordnet, der unter einem Winkel von etwa 45° zur optischen Achse des Kamera-Chips 410 angeordnet ist. Der halbdurchlässige Spiegel 420 dient dazu, farbiges Licht zweier Erfassungsspektren, hier dem grünen Farbbereich und dem blauen Farbbereich, aus entsprechenden Lichtquellen 440 optisch einzukoppeln und auf eine Deckfläche des Bauteils B zu richten. Dieses auf das Bauteil B gerichtete Licht im grünen und im blauen Farbbereich erfasst der Kamera-Chip 410. Je nach räumlichen Gegebenheiten können auch andere Umlenkspiegel, Prismen, Farbfilter oder Linsen vorgesehen sein.

Eine weitere Lichtquelle 450 ist in einer Ausgestaltung als Ringlichtquelle um die an der Ablegestelle ABS befindliche Empfangsstelle ES1 angeordnet und liefert Streulicht unter einem Winkel von etwa 5° - 45° im roten Farbbereich auf die Deckfläche des Bauteils B. Auch dieses auf das Bauteil B gerichtete Licht im roten Farbbereich erfasst der Kamera-Chip 410.

Einzelne der optisch wirksamen Elemente und/oder der Strahlungsquellen können dazu eingerichtet sein, unabhängig von anderen ausgerichtet und/oder justiert / fokussiert zu werden.

Der Kamera-Chip 410 ist in der vorliegenden Variante eine Farbkamera mit drei einzelnen Kanälen R, G, B. Es kann aber auch eine Kamera mit mehreren Kanälen sein. Die drei Farbkanäle der Kamera sind getrennt voneinander ansprechbar/ auszulesen. Mit einer einzigen Bildaufnahme wird das Bauteil B auf Fehler inspiziert, zum Beispiel das schräge Ablegen des Bauteils B, so dass es nicht korrekt in der vorgesehenen Tasche des Trägers 320 positioniert ist, oder auf Qualitätsmängel. Außerdem werden durch diese einzige Bildaufnahme die exakten Positionsdaten der Tasche des Trägers 320 für das Ablegen des nächsten Bauteils B erfasst. Die aus den einzelnen Farbkanälen zu gewinnende Information teilt sich wie folgt auf: Bildkanal 1 mit Beleuchtungstyp 1: Position der Ablagetasche des Ablagebandes zur Positionierung des nächsten Bauteils. Bildkanal 2 mit Beleuchtungstyp 2: Qualitätsinspektion des Bauteils (Risse, Lasermarken, Ausbrüche, ...). Bildkanal 3 mit Beleuchtungstyp 3: Zusatzinspektionen für spezielle Bauteile oder kundenspezifische Fehler.

Durch die hier vorgestellte bildgebende Sensorik sind weniger Bildeinzüge erforderlich als mit herkömmlichen Sensoranordnungen um eine Schlechtteilausschleusung und eine Positionierung der Aktoren zu realisieren.

Es sei bemerkt, dass obwohl hier numerische Bereiche und numerische Werte offenbart wurden, alle numerischen Werte zwischen den offenbarten Werten und jedem numerischen Unterbereich innerhalb der genannten Bereiche als ebenfalls offenbart anzusehen sind.

Die vorangehend beschriebenen Varianten der Vorrichtung sowie deren Aufbau- und Betriebsaspekte dienen lediglich dem besseren Verständnis der Struktur, der Funktionsweise und der Eigenschaften; sie schränken die Offenbarung nicht etwa auf die Ausführungsbeispiele ein. Die Fig. sind teilweise schematisch, wobei wesentliche Eigenschaften und Effekte zum Teil deutlich vergrößert dargestellt sind, um die Funktionen, Wirkprinzipien, technischen Ausgestaltungen und Merkmale zu verdeutlichen. Dabei kann jede Funktionsweise, jedes Prinzip, jede technische Ausgestaltung und jedes Merkmal, welches/welche in den Fig. oder im Text offenbart ist/sind, mit allen Ansprüchen, jedem Merkmal im Text und in den anderen Fig., anderen Funktionsweisen, Prinzipien, technischen Ausgestaltungen und Merkmalen, die in dieser Offenbarung enthalten sind oder sich daraus ergeben, frei und beliebig kombiniert werden, so dass alle denkbaren Kombinationen der beschriebenen Vorgehensweise zuzuordnen sind. Dabei sind auch Kombinationen zwischen allen einzelnen Ausführungen im Text, das heißt in jedem Abschnitt der Beschreibung, in den Ansprüchen und auch Kombinationen zwischen verschiedenen Varianten im Text, in den Ansprüchen und in den Fig. umfasst. Auch die Ansprüche limitieren nicht die Offenbarung und damit die Kombinationsmöglichkeiten aller aufgezeigten Merkmale untereinander. Alle offenbarten Merkmale sind explizit auch einzeln und in Kombination mit allen anderen Merkmalen hier offenbart. Der Schutzumfang wird jedoch durch die beigefügten Ansprüche definiert.

### Bezugszeichen

Ablagestelle **ABS**
Bauteil **B**
Seitenflächen **S1, S2, S3, S4** des Bauteils
Deckflächen **D1, D2** des Bauteils
erster Drehantrieb **DA1** zum Drehen der ersten Wendeeinrichtung um erste Achse (X-Achse)
zweiter Drehantrieb **DA2** zum Drehen der zweiten Wendeeinrichtung um zweite Achse (Y-Achse)
dritter Drehantrieb **DA3** zum Drehen der Empfangseinrichtung um eine die Ablagestelle ABS enthaltende dritte Achse (Z-Achse)
vierter Drehantrieb **DA4** der Empfangseinrichtung transportiert den Träger in Förderrichtung
erster Linearantrieb **LA1** zum Verfahren der ersten Wendeeinrichtung längs erster Achse (X-Achse)
zweiter Linearantrieb **LA2** zum Verfahren der zweiten Wendeeinrichtung längs zweiter Achse (Y-Achse)
dritter Linearantrieb **LA3** zum Verfahren der Empfangseinrichtung längs erster Achse
vierter Linearantrieb **LA4** zum Verfahren der Empfangseinrichtung längs zweiter Achse
fünfter Linearantrieb **LA5** zum Verfahren eines durch die Empfangseinrichtung geführten Trägers längs erster Achse (X-Achse)
erste Empfangsstelle **ES1**
zweite Empfangsstelle **ES2**
Steuerung **ECU**
Lage- und Eigenschaftssensoren **K1** ... **K11**
erste Kameraanordnung **K1** im Zentrum der ersten Wendeeinrichtung senkrecht nach oben gerichtet
zweite Kameraanordnung **K2** mit drei Kameras ist an der Peripherie der ersten Wendeeinrichtung bei 90° auf das daran vorbeigeführte Bauteil gerichtet
dritte Kameraanordnung **K3** mit drei Kameras ist an der Peripherie der zweiten Wendeeinrichtung bei 90° auf das daran vorbeigeführte Bauteil gerichtet
vierte Kameraanordnung **K4** ist im Zentrum der zweiten Wendeeinrichtung auf die Ablagestelle oder die erste Empfangsstelle in der Empfangseinrichtung gerichtet
fünfte Kameraanordnung **K5** ist auf zweites Fenster an der zweiten Empfangsstelle gerichtet
siebte Kameraanordnung **K7** ist im Zentrum der ersten Wendeeinrichtung auf die Übergabestelle ÜS gerichtet
achte Kameraanordnung **K8** mit zwei Kameras ist an der Peripherie der Wendeeinrichtungen aus zwei zueinander orthogonalen Erfassungsrichtungen auf die Spendestelle gerichtet
neunte Kameraanordnung **K9** mit zwei Kameras ist an der Peripherie der Wendeeinrichtungen aus zwei zueinander orthogonalen Erfassungsrichtungen auf die Übergabestelle gerichtet
zehnte Kameraanordnung **K10** mit zwei Kameras ist an der Peripherie der Wendeeinrichtungen aus zwei zueinander orthogonalen Erfassungsrichtungen auf die Ablagestelle gerichtet
elfte Kameraanordnung **K11** ist im Zentrum der zweiten Wendeeinrichtung auf die Übergabestelle ÜS gerichtet
Spiegel **SP1, SP2**
Spendestelle **SPS**
Übergabestelle **ÜS**
Bauteilhandhabungsvorrichtung **100**
Ausstoßeinheit **110**
erste Wendeeinrichtung **130**
erste Aufnehmer **132**
zweite Wendeeinrichtung **150**
zweite Aufnehmer **152**
Empfangseinrichtung **200**
Träger **320**
Transportlöcher **325**
erster Absauger **330**
Ausschleusstelle **335**
Absaug- und/oder Ausblaseinrichtung **340**
Sensor **400**
Kamera-Chip **410**
halbdurchlässiger Spiegel **420**
Lichtquellen **440**
weitere Lichtquelle **450**

## Patentansprüche

1. Vorrichtung zum Selbstjustieren einer Bauteilhandhabungsvorrichtung (100) für elektronische Bauteile (B), welche dazu ausgebildet und angeordnet ist, die Bauteile (B) von einer Abgabeeinrichtung (110) an einer Spendestelle (SPS) an eine erste justierbare Wendeeinrichtung (130) mit mehreren Aufnehmern (132) zu übergeben, und
das empfangene Bauteil (B) um einen ersten vorbestimmten Winkel um seine Längs- oder Querachse (LA, QA) zu wenden, zu einer Ablagestelle (AS) zu fördern und dort auf eine justierbare Empfangseinrichtung (200) an einer vorbestimmten Empfangsstelle (ES1) abzulegen, umfassend:
eine erste Justierungssensoranordnung (K1, K8) gerichtet auf die Spendestelle (SPS), welche ausgebildet und angeordnet ist,
eine Position des an der Spendestelle (SPS) positionierten Aufnehmers (132) in Relation zur Abgabeeinrichtung (110) zu erfassen, und
eine zweite Justierungssensoranordnung gerichtet auf die Ablagestelle (AS), welche ausgebildet und angeordnet ist,
eine Position der Empfangsstelle (ES1) in Relation zur Position des an der Ablagestelle (AS) positionierten Aufnehmers (132) zu erfassen, wobei
die erste und die zweite Justierungssensoranordnung jeweils dazu ausgebildet und angeordnet sind, die Spendestelle (SPS) / die Ablagestelle (AS) aus mindestens zwei voneinander verschiedenen Erfassungsrichtungen zu erfassen, und
die erste und zweite Justierungssensoranordnung jeweils dazu ausgebildet und angeordnet sind, einer nachgeordneten Steuerung Bildeinzüge für jede Übertragungsstellung der ersten Wendeeinrichtung (130) bereitzustellen, wobei
die Steuerung anhand der gewonnenen Bildauszüge für jede Übertragungsstellung der ersten Wendeeinrichtung (130) einen Korrekturvektor ermittelt, welcher während des Betriebs der Bauteilhandhabungsvorrichtung (100) zur Justierung der ersten Wendeeinrichtung (130) und/oder der einzelnen Aufnehmer (132) und/oder der Empfangseinrichtung (200) dient.

2. Vorrichtung nach Anspruch 1 weiter umfassend:
eine aus der Peripherie der ersten Wendeeinrichtung (130) bei 90° auf den daran vorbeigeführten Aufnehmer (132) gerichteten Lage- und Eigenschaftssensor (K3), welcher insbesondere ein Kamerasensor ist, der dazu ausgebildet und angeordnet ist, eine Position des Aufnehmers (132) relativ zu einem zuvor definierten Referenzpunkt zu bestimmen.

3. Vorrichtung nach Anspruch 1, wobei die erste Justierungssensoranordnung und/oder die zweite Justierungssensoranordnung aus jeweils einem ersten bildgebenden Sensor, insbesondere einer ersten Kamera, und einem zweiten bildgebenden Sensor, insbesondere einer zweiten Kamera, bestehen.

4. Vorrichtung nach Anspruch 1, wobei
die erste Justierungssensoranordnung und/oder die zweite Justierungssensoranordnung aus je einem, aus dem Zentrum der ersten Wendeeinrichtung (130) heraus senkrecht auf die Spendestelle (SPS) oder die Ablagestelle (AS) gerichteten, bildgebenden Sensor, insbesondere einer Kamera, und mindestens zwei zueinander rechtwinklig angeordneten Reflektoren, insbesondere Spiegeln, bestehen, wobei
der bildgebenden Sensor, dazu geeignet und bestimmt ist, die Spendestelle (SPS) oder die Ablagestelle (AS) indirekt aus einer ersten und zweiten Erfassungsrichtung zu erfassen, wobei
die Reflektoren so angeordnet sind, dass die beiden Erfassungsrichtungen orthogonal zueinander verlaufen.

5. Vorrichtung nach einem der vorangegangenen Ansprüche wobei,
die Steuerung dazu geeignet und bestimmt ist, anhand der durch die Justierungssensoranordnungen gewonnenen Bildeinzüge die Position des an der Spendestelle (SPS) befindlichen Aufnehmers (132) in Relation zu der Abgabeeinrichtung (110) zu bestimmen und zu speichern, und
die Position der Empfangsstelle (ES1) in Relation zu dem an der Ablagestelle (AS) befindlichen Aufnehmer (132) zu bestimmen und zu speichern, und/oder
einen Positionsabweichung des jeweiligen Aufnehmers (132) zu einer zuvor definierten Position gemäß Anspruch 2 zu bestimmen und zu speichern, und
anhand der bestimmten Positionen einen Korrekturvektor für die Position der einzelnen Aufnhemer (132) und/oder für die erste Wendeeinrichtung (130), an der die Aufnehmer (132) befestigt sind, zu ermitteln, und/oder
anhand der bestimmten Positionen einen Korrekturvektor für die Empfangseinrichtung (200), zu ermitteln, und
jeweils weitere Korrekturvektoren für jede Übergabestellung der ersten Wendeeinrichtung (130) auf die gleiche Weise zu bestimmen, und
die Positionierung der ersten Wendeeinrichtung (130) und/oder der einzelnen Aufnehmer (132) während des Betriebs zu steuern, um der Abweichung zwischen der bestimmten Position der Aufnehmer (132) relativ zur Position der Ausstoßeinheit (110) entgegen zu wirken, und
die Positionierung der Empfangseinrichtung (200) und/oder der einzelnen Aufnehmer (132) während des Betriebs zu steuern, um der Abweichung zwischen der bestimmten Position der Empfangsstelle (ES1) relativ zur Position der Aufnehmer (132) entgegen zu wirken, und/oder
die Position des Aufnehmers (132) relativ zu der Position der Abgabeeinrichtung (110) und/oder zu der Position der Empfangsstelle (ES1) mit der Position des Aufnehmers (132) relativ zu dem definierten Referenzpunkt gemäß Anspruch 2 zu vergleichen.

6. Vorrichtung nach einem der vorangegangenen Ansprüche, wobei die erste und/oder zweite Justierungssensoranordnung dauerhaft mit der Bauteilhandhabungsvorrichtung (100) verbunden ist, und/oder der Lage- und Eigenschaftssensor (K3) gemäß Anspruch 2 dauerhaft mit der Bauteilhandhabungsvorrichtung (100) verbunden ist.

7. Vorrichtung nach einem der vorangegangenen Ansprüche, weiter umfassend:
eine zweite justierbare Wendeeinrichtung (150) mit mehreren Aufnahmen, welche dazu ausgebildet und angeordnet ist, das Bauteil an einer Übergabestelle (ÜS) von einem Aufnehmer (132) der ersten Wendeeinrichtung (130) zu empfangen, das empfangene Bauteil (B) um einen zweiten vorbestimmten Winkel um seine Längs- oder Querachse (LA, QA) zu wenden, zu der Ablagestelle (AS) zu fördern und dort auf eine justierbare Empfangseinrichtung (200) an der vorbestimmten Empfangsstelle (ES1) abzulegen, weiter umfassend
eine dritte Justierungssensoranordnung, gerichtet auf die Übergabestelle (ÜS) zwischen erster Wendeeinrichtung (130) und zweiter Wendeeinrichtung (150), welche dazu ausgebildet und angeordnet ist, eine Position des an der Übergabestelle (ÜS) positionierten Aufnehmers (152) der zweiten Wendeeinrichtung (150) in Relation zum an der Übergabestelle (ÜS) positionierten Aufnehmer (132) der ersten Wendeeinrichtung (130) zu erfassen.

8. Verfahren zum Selbstjustieren einer Bauteilhandhabungsvorrichtung (100), welche elektronische Bauteile (B) von einer Abgabeeinrichtung (110) an einer Spendestelle (SPS) an eine erste Wendeeinrichtung (130) mit mehreren Aufnehmern (132) übergibt, und
die empfangenen Bauteile (B) um einen ersten vorbestimmten Winkel um ihre Längs- oder Querachse (LA, QA) wendet, sie zu einer Ablagestelle (AS) fördert und dort auf eine justierbare Empfangseinrichtung (200) an einer vorbestimmten Empfangsstelle (ES1) ablegt und folgende Verfahrensschritte aufweist:
- Erfassen der Spendestelle (SPS), beinhaltend die Abgabeeinrichtung (110) und den an dieser Stelle befindlichen Aufnehmer (132), aus mindestens zwei voneinander verschiedenen Erfassungsrichtungen, durch eine Justierungssensoranordnung,
- Erfassen der Ablagestelle (AS), beinhaltend den an dieser Stelle befindlichen Aufnehmer (132) und die Empfangsstelle (ES1), aus mindestens zwei voneinander verschiedenen Erfassungsrichtungen, durch eine Justierungssensoranordnung,
- Ermitteln der Position des an der Spendestelle (SPS) befindlichen Aufnehmers (132) in Relation zur Abgabeeinrichtung (110), und
Ermitteln einer Abweichung zu einer zuvor definierten Position des Aufnehmers (132),
- Ermitteln der Position der Empfangsstelle (ES1) in Relation zu dem an der Ablagestelle (AS) befindlichen Aufnehmer (132), und
Ermitteln einer Abweichung zu einer zuvor definierten Position der Empfangsstelle (ES1),
- Ermitteln, anhand der zuvor ermittelten Abweichungen, eines Korrekturvektors für die erste Wendeeinrichtung (130) und/oder für jeden einzelnen Aufnehmer (132) und/oder für die Empfangseinrichtung (200),
- Wiederholung aller vorherigen Verfahrensschritte für jede mögliche Übertragungsstellung der ersten Wendeeinrichtung (130), und
- Steuern der Positionierung der ersten Wendeeinrichtung (130) und/oder der Empfangseinrichtung (200) und/oder jedes einzelnen Aufnehmers (132) während des Betriebs der Bauteilhandhabungsvorrichtung (100) so, dass der Abweichung zwischen der ermittelten und der definierten Position der Aufnehmer (132) und/oder der Empfangsstelle (ES1) in jeder möglichen Übertragungsstellung jeweils entgegen gewirkt wird.

9. Verfahren nach Anspruch 8, weiter umfassend:
- Erfassen einer Position des Aufnehmers (132) in Relation zu einem zuvor definierten Referenzpunkt durch einen Lage- und Eigenschaftssensor (K3), welcher insbesondere ein Kamerasensor ist, und
- Vergleich der ermittelten relativen Position des Aufnehmers (132) zur Empfangsstelle (ES1) und/oder zur Abgabeeinrichtung (110) mit der relativen Position des Aufnehmers (132) zum definierten Referenzpunkt, und
- Wiederholung aller vorherigen Verfahrensschritte für jede mögliche Übertragungsstellung der ersten Wendeeinrichtung (130).

10. Verfahren nach Anspruch 8 oder 9, wobei die elektronischen Bauteile (B) von der ersten justierbaren Wendeeinrichtung (130) an einer Übergabestelle (ÜS) auf eine zweite justierbare Wendeeinrichtung (150) übergeben werden, und
die empfangenen Bauteile (B) von dieser um einen zweiten vorbestimmten Winkel um ihre Längs- oder Querachse (LA, QA) gewendet werden, zu einer Ablagestelle (AS) gefördert werden und dort auf eine justierbare Empfangseinrichtung (200) an einer vorbestimmten Empfangsstelle (ES1) abgelegt werden, wobei das Verfahren folgende weitere Schritte umfasst:
- Erfassen der Ablagestelle (ÜS), beinhaltend den an dieser Stelle befindlichen Aufnehmer (132) der ersten Wendeeinrichtung (130) und den an dieser Stelle befindlichen Aufnehmer (152) der zweiten Wendeeinrichtung (150), aus mindestens zwei voneinander verschiedenen Erfassungsrichtungen, durch eine Justierungssensoranordnung, und
- Ermitteln der Position des an der Übergabestelle (ÜS) befindlichen Aufnehmers (152) der zweiten Wendeeinrichtung (150) in Relation zu dem an der Übergabestelle (ÜS) befindlichem Aufnehmer (132) der ersten Wendeeinrichtung (130), und
- Ermitteln einer Abweichung zu einer zuvor definierten Position des Aufnehmers (152),
- Steuern der Positionierung der zweiten Wendeeinrichtung (150) und/oder jedes einzelnen Aufnehmers (152) während des Betriebs der Bauteilhandhabungsvorrichtung (100) so, dass der Abweichung zwischen der ermittelten und der definierten Position der Aufnehmer (152) in jeder möglichen Übertragungsstellung jeweils entgegen gewirkt wird.

11. Verfahren nach einem der vorhergehenden Ansprüche, wobei ein Prüfen der Erfassungsqualität der Justierungssensoranordnung und/oder ein Prüfen des Aufnehmers (132) auf Beschädigung anhand der Vergleiche erfolgt.

## Claims

1. A device for the self-adjustment of a component-handling device (100) for electronic components (B), which is designed and arranged to transfer the components (B) from a delivery device (110) at a dispensing point (SPS) to a first adjustable turning device (130) having a plurality of pick-up elements (132), and
to turn the received component (B) through a first predetermined angle about its longitudinal or transverse axis (LA, QA), to feed it to a deposit point (AS), and to deposit it there on an adjustable reception device (200) at a predetermined reception point (ES1), comprising:
a first adjustment sensor arrangement (K1, K8) directed at the dispensing point (SPS), which is designed and arranged
to detect a position of the pick-up element (132) positioned at the dispensing point (SPS) in relation to the delivery device (110), and
a second adjustment sensor arrangement directed at the deposit point (AS), which is designed and arranged
to detect a position of the reception point (ES1) in relation to the position of the pick-up element (132) positioned at the deposit point (AS), wherein
the first and the second adjustment sensor arrangements are each designed and arranged to detect the dispensing point (SPS)/the deposit point (AS) from at least two detection directions which are different from one another, and
the first and second adjustment sensor arrangements are each designed and arranged to provide image acquisitions for each transfer position of the first turning device (130) to a downstream controller, wherein
for each transfer position of the first turning device (130), the controller determines, on the basis of the image acquisitions obtained, a correction vector which is used during operation of the component-handling device (100) to adjust the first turning device (130) and/or the individual pick-up elements (132) and/or the reception device (200).

2. The device as claimed in claim 1, further comprising:
a position and property sensor (K3) which is directed from the periphery of the first turning device (130) at 90° at the pick-up elements (132) guided past thereon and which is in particular a camera sensor which is designed and arranged to determine a position of the pick-up element (132) relative to a previously defined reference point.

3. The device as claimed in claim 1, wherein the first adjustment sensor arrangement and/or the second adjustment sensor arrangement each consist of a first imaging sensor, in particular a first camera, and a second imaging sensor, in particular a second camera.

4. The device as claimed in claim 1, wherein
the first adjustment sensor arrangement and/or the second adjustment sensor arrangement each consist of an imaging sensor, in particular a camera, directed from the center of the first turning device (130) perpendicularly at the dispensing point (SPS) or the deposit point (AS), and at least two reflectors, in particular mirrors, arranged at right angles to one another, wherein
the imaging sensor is suitable and intended for detecting the dispensing point (SPS) or the deposit point (AS) indirectly from a first and second detection direction, wherein
the reflectors are so arranged that the two detection directions are orthogonal to one another.

5. The device as claimed in any one of the preceding claims, wherein
the controller is suitable and intended, on the basis of the image acquisitions obtained by the adjustment sensor arrangements, for determining and storing the position of the pick-up element (132) situated at the dispensing point (SPS) in relation to the delivery device (110), and
determining and storing the position of the reception point (ES1) in relation to the pick-up element (132) situated at the deposit point (AS), and/or
determining and storing a position deviation of the particular pick-up element (132) from a previously defined position according to claim 2, and
on the basis of the determined positions, determining a correction vector for the position of the individual pick-up elements (132) and/or for the first turning device (130) to which the pick-up elements (132) are fixed, and/or
on the basis of the determined positions, determining a correction vector for the reception device (200), and
determining further correction vectors for each transfer position of the first turning device (130) in the same manner, and
controlling the positioning of the first turning device (130) and/or of the individual pick-up elements (132) during operation in order to counteract the deviation between the determined position of the pick-up elements (132) relative to the position of the ejection unit (110), and
controlling the positioning of the reception device (200) and/or of the individual pick-up elements (132) during operation in order to counteract the deviation between the determined position of the reception point (ES1) relative to the position of the pick-up elements (132), and/or
comparing the position of the pick-up element (132) relative to the position of the delivery device (110) and/or to the position of the reception point (ES1) with the position of the pick-up element (132) relative to the defined reference point according to claim 2.

6. The device as claimed in any one of the preceding claims, wherein the first and/or second adjustment sensor arrangement is permanently connected to the component-handling device (100), and/or
the position and property sensor (K3) according to claim 2 is permanently connected to the component-handling device (100).

7. The device as claimed in any one of the preceding claims, further comprising:
a second adjustable turning device (150) having a plurality of pick-up elements, which is designed and arranged to receive the component at a transfer point (ÜS) from a pick-up element (132) of the first turning device (130), to turn the received component (B) through a second predetermined angle about its longitudinal or transverse axis (LA, QA), to feed it to the deposit point (AS) and to deposit it there on an adjustable reception device (200) at the predetermined reception point (ES1), further comprising
a third adjustment sensor arrangement, directed at the transfer point (US) between the first turning device (130) and the second turning device (150), which is designed and arranged to detect a position of the pick-up element (152) of the second turning device (150) positioned at the transfer point (US) in relation to the pick-up element (132) of the first turning device (130) positioned at the transfer point (ÜS).

8. A method for the self-adjustment of a component-handling device (100) which transfers electronic components (B) from a delivery device (110) at a dispensing point (SPS) to a first turning device (130) having a plurality of pick-up elements (132), and
turns the received components (B) through a first predetermined angle about their longitudinal or transverse axis (LA, QA), feeds them to a deposit point (AS) and deposits them there on an adjustable reception device (200) at a predetermined reception point (ES1) and comprises the following process steps:
- detecting the dispensing point (SPS), containing the delivery device (110) and the pick-up element (132) situated at that point, from at least two detection directions which are different from one another, by means of an adjustment sensor arrangement,
- detecting the deposit point (AS), containing the pick-up element (132) situated at that point and the reception point (ES1), from at least two detection directions which are different from one another, by means of an adjustment sensor arrangement,
- determining the position of the pick-up element (132) situated at the dispensing point (SPS) in relation to the delivery device (110), and
determining a deviation from a previously defined position of the pick-up element (132),
- determining the position of the reception point (ES1) in relation to the pick-up element (132) situated at the deposit point (AS), and
determining a deviation from a previously defined position of the reception point (ES1),
- determining, on the basis of the previously determined deviations, a correction vector for the first turning device (130) and/or for each individual pick-up element (132) and/or for the reception device (200),
- repeating all the preceding method steps for every possible transfer position of the first turning device (130), and
- controlling the positioning of the first turning device (130) and/or of the reception device (200) and/or of each individual pick-up element (132) during operation of the component-handling device (100) so that the deviation between the determined and the defined position of the pick-up elements (132) and/or of the reception point (ES1) is counteracted in every possible transfer position.

9. The method as claimed in claim 8, further comprising:
- detecting a position of the pick-up element (132) in relation to a previously defined reference point by means of a position and property sensor (K3) which in particular is a camera sensor, and
- comparing the determined relative position of the pick-up element (132) to the reception point (ES1) and/or to the delivery device (110) with the relative position of the pick-up element (132) to the defined reference point, and
- repeating all the preceding method steps for every possible transfer position of the first turning device (130).

10. The method as claimed in claim 8 or 9, wherein the electronic components (B) are transferred at a transfer point (US) from the first adjustable turning device (130) to a second adjustable turning device (150), and
the received components (B) are turned by the second turning device through a second predetermined angle about their longitudinal or transverse axis (LA, QA), fed to a deposit point (AS) and deposited there on an adjustable reception device (200) at a predetermined reception point (ES1), wherein the method comprises the following further steps:
- detecting the deposit point (US), containing the pick-up element (132) of the first turning device (130) situated at that point and the pick-up element (152) of the second turning device (150) situated at that point, from at least two detection directions which are different from one another, by means of an adjustment sensor arrangement, and
- determining the position of the pick-up element (152) of the second turning device (150) situated at the transfer point (US) in relation to the pick-up element (132) of the first turning device (130) situated at the transfer point (ÜS), and
- determining a deviation from a previously defined position of the pick-up element (152),
- controlling the positioning of the second turning device (150) and/or of each individual pick-up element (152) during operation of the component-handling device (100) so that the deviation between the determined and the defined position of the pick-up elements (152) is counteracted in every possible transfer position.

11. The method as claimed in any one of the preceding claims, wherein a check of the detection quality of the adjustment sensor arrangement and/or a check of the pick-up element (132) for damage is carried out on the basis of the comparisons.

## Revendications

1. Dispositif d'auto-ajustement d'un dispositif de manipulation de composants (100) pour des composants électroniques (B), qui est conçu et disposé pour transférer les composants (B) d'un dispositif de distribution (110) au niveau d'un point de distribution (SPS) à un premier dispositif de retournement (130) ajustable comprenant plusieurs éléments de réception (132), et
tourner le composant (B) reçu selon un premier angle prédéfini autour de son axe longitudinal ou transversal (LA, QA), le transporter vers un point de dépôt (AS), et l'y déposer ensuite sur un dispositif de réception (200) ajustable au niveau d'un point de réception (ES1) prédéfini, comprenant :
un premier agencement de capteurs d'ajustement (K1, K8) dirigé vers le point de distribution (SPS), conçu et disposé pour
détecter une position de l'élément de réception (132) positionné au niveau du point de distribution (SPS), par rapport au dispositif de distribution (110), et
un deuxième agencement de capteurs d'ajustement dirigé vers le point de dépôt (AS), conçu et disposé pour
détecter une position du point de réception (ES1) par rapport à la position de l'élément de réception (132) positionné au niveau du point de dépôt (AS), dans lequel
les premier et deuxième agencements de capteurs d'ajustement sont chacun conçus et disposés pour détecter le point de distribution (SPS) / le point de dépôt (AS) depuis au moins deux directions de détection distinctes l'une de l'autre, et dans lequel
les premier et deuxième agencements de capteurs d'ajustement sont chacun conçus et disposés pour fournir à un organe de commande en aval des acquisitions d'images pour chaque position de transfert du premier dispositif de retournement (130), dans lequel
l'organe de commande détermine moyennant les images obtenues pour chaque position de transfert du premier dispositif de retournement (130) un vecteur de correction qui sert à ajuster le premier dispositif de retournement (130) et/ou les différents éléments de réception (132) et/ou le dispositif de réception (200) pendant le fonctionnement du dispositif de manipulation de composants (100).

2. Dispositif selon la revendication 1, comprenant en outre :
un capteur de position et de propriétés (K3) dirigé à 90° depuis la périphérie du premier dispositif de retournement (130) sur l'élément de réception (132) défilant devant ce dernier, qui est notamment un capteur de caméra conçu et disposé pour déterminer une position de l'élément de réception (132) par rapport à un point de référence défini précédemment.

3. Dispositif selon la revendication 1, dans lequel le premier agencement de capteurs d'ajustement et/ou le deuxième agencement de capteurs d'ajustement sont composés chacun d'un premier capteur générateur d'images, notamment d'une première caméra, et d'un deuxième capteur générateur d'images, notamment d'une deuxième caméra.

4. Dispositif selon la revendication 1, dans lequel
le premier agencement de capteurs d'ajustement et/ou le deuxième agencement de capteurs d'ajustement sont chacun composés d'un capteur générateur d'images, notamment d'une caméra, dirigé perpendiculairement vers le point de distribution (SPS) ou le point de dépôt (AS) depuis le centre du premier dispositif de retournement (130) et d'au moins deux réflecteurs, notamment des miroirs, disposés perpendiculairement entre eux, dans lequel
le capteur générateur d'images est apte et destiné à détecter le point de distribution (SPS) ou le point de dépôt (AS) indirectement depuis une première et une seconde direction de détection, dans lequel
les réflecteurs sont disposés de manière à ce que les deux directions de détection soient orthogonales entre elles.

5. Dispositif selon l'une des revendications précédentes, dans lequel
l'organe de commande est apte et destiné à déterminer et à enregistrer, moyennant les acquisitions d'images des agencements de capteurs d'ajustement, la position de l'élément de réception (132) situé au niveau du point de distribution (SPS) par rapport au dispositif de distribution (110) et
à déterminer et à enregistrer la position du point de réception (ES1) par rapport à l'élément de réception (132) situé au niveau du point de dépôt (AS), et/ou
à déterminer et à enregistrer un écart de position du dispositif de réception (132) considéré par rapport à une position définie précédemment conformément à la revendication 2, et
à déterminer, à partir des positions définies, un vecteur de correction pour la position des différents éléments de réception (132) et/ou pour le premier dispositif de retournement (130) sur lequel sont fixés les éléments de réception (132), et/ou
à déterminer, à partir des positions définies, un vecteur de correction pour le dispositif de réception (200), et
à déterminer de la même façon d'autres vecteurs de correction pour chaque position de transfert du premier dispositif de retournement (130), et
à piloter le positionnement du premier dispositif de retournement (130) et/ou des différents éléments de réception (132) pendant le fonctionnement de manière à éviter l'écart entre la position définie des éléments de réception (132) par rapport à la position de l'unité d'éjection (110), et
à piloter le positionnement du dispositif de réception (200) et/ou des différents éléments de réception (132) pendant le fonctionnement de manière à éviter l'écart entre la position définie du point de réception (ES1) par rapport à la position des éléments de réception (132), et/ou
à comparer la position de l'élément de réception (132) par rapport à la position du dispositif de distribution (110) et/ou par rapport à la position du point de réception (ES1) avec la position de l'élément de réception (132) par rapport au point de référence défini selon la revendication 2.

6. Dispositif selon l'une des revendications précédentes, dans lequel le premier et/ou le deuxième agencement de capteurs d'ajustement est(sont) relié(s) en permanence au dispositif de manipulation de composants (100), et/ou
le capteur de position et de propriétés (K3) selon la revendication 2 est relié en permanence au dispositif de manipulation de composants (100).

7. Dispositif selon l'une des revendications précédentes, comprenant en outre :
un second dispositif de retournement (150) avec plusieurs éléments de réception, qui est conçu et disposé pour réceptionner au niveau d'un point de transfert (ÜS) le composant d'un élément de réception (132) du premier dispositif de retournement (130), tourner le composant (B) réceptionné sur un second angle prédéfini autour de son axe longitudinal ou transversal (LA, QA), le transporter vers le point de dépôt (AS), puis l'y déposer sur un dispositif de réception (200) ajustable au niveau du point de réception (ES1) prédéfini, comprenant en outre
un troisième agencement de capteurs d'ajustement dirigé vers le point de transfert (ÜS) entre le premier dispositif de retournement (130) et le second dispositif de retournement (150), conçu et disposé pour détecter une position de l'élément de réception (152) du second dispositif de retournement (150) positionné au niveau du point de transfert (ÜS) par rapport à l'élément de réception (132) du premier dispositif de retournement (130) positionné au niveau du point de transfert (ÜS).

8. Procédé d'auto-ajustement d'un dispositif de manipulation de composants (100) qui transfère, au niveau d'un point de distribution (SPS), des composants (B) électroniques d'un dispositif de distribution (110) à un dispositif de retournement (130) comportant plusieurs éléments de réception (132), et
tourne les composants (B) reçus selon un premier angle prédéfini autour de leur axe longitudinal ou transversal (LA, QA), les transporte vers un point de dépôt (AS), et les y dépose ensuite sur un dispositif de réception (200) ajustable au niveau du point de réception (ES1) prédéfini, et comprend les étapes suivantes :
- détection par un agencement de capteurs d'ajustement du point de distribution (SPS) comprenant le dispositif de distribution (110) et l'élément de réception (132) situé à cet endroit, depuis au moins deux directions de détection distinctes l'une de l'autre,
- détection par un agencement de capteurs d'ajustement du point de dépôt (AS) comprenant l'élément de réception (132) situé à cet endroit et le point de réception (ES1), depuis au moins deux directions de détection distinctes l'une de l'autre,
- détermination de la position de l'élément de réception (132) situé au niveau du point de distribution (SPS) par rapport au dispositif de distribution (110), et
- détermination d'un écart par rapport à une position de l'élément de réception (132) définie précédemment,
- détermination de la position du point de réception (ES1) par rapport à l'élément de réception (132) situé au niveau du point de dépôt (AS), et
- détermination d'un écart par rapport à une position du point de réception (ES1) définie précédemment,
- détermination, à partir des écarts déterminés précédemment, d'un vecteur de correction pour le premier dispositif de retournement (130) et/ou pour chacun des éléments de réception (132) et/ou pour le dispositif de réception (200),
- répétition de toutes les étapes précédentes du procédé pour chaque position de transfert possible du premier dispositif de retournement (130), et
- pilotage du positionnement du premier dispositif de retournement (130) et/ou du dispositif de réception (200) et/ou de chacun des éléments de réception (132) pendant le fonctionnement du dispositif de manipulation de composants (100), de telle manière que l'écart entre la position déterminée et la position définie des éléments de réception (132) et/ou du point de réception (ES1) soit évité dans toutes les positions de transfert possibles.

9. Procédé selon la revendication 8, comportant en outre :
- détection par un capteur de position et de propriétés (K3), qui est notamment un capteur de caméra, d'une position de l'élément de réception (132) par rapport à un point de référence défini précédemment, et
- comparaison de la position relative de l'élément de réception (132) déterminée, par rapport au point de réception (ES1) et/ou par rapport au dispositif de distribution (110), et de la position de l'élément de réception (132) par rapport au point de référence défini et
- répétition de toutes les étapes précédentes du procédé pour chaque position de transfert possible du premier dispositif de retournement (130).

10. Procédé selon la revendication 8 ou 9, dans lequel les composants (B) électroniques sont transférés, au niveau d'un point de transfert (ÜS), d'un premier dispositif de retournement (130) ajustable à un second dispositif de retournement (150) ajustable, et dans lequel
les composants (B) reçus sont tournés par ce dernier selon un second angle prédéfini autour de leur axe longitudinal ou transversal (LA, QA), transportés vers un point de dépôt (AS), et y sont déposés ensuite sur un dispositif de réception (200) ajustable au niveau du point de réception (ES1) prédéfini, le procédé comprenant les étapes supplémentaires suivantes :
- détection, moyennant un agencement de capteurs d'ajustement, du point de dépôt (AS) comprenant l'élément de réception (132) du premier dispositif de retournement (130) se trouvant à cet endroit et l'élément de réception (152) du premier dispositif de retournement (150) se trouvant à cet endroit, à partir d'au moins deux directions de détection distinctes l'une de l'autre, et
- détermination de la position de l'élément de réception (152) du second dispositif de retournement (150), qui se trouve au niveau du point de transfert (ÜS), par rapport à l'élément de réception (132) du premier dispositif de retournement (130), qui se trouve au niveau du point de transfert (ÜS), et
- détermination d'un écart par rapport à une position de l'élément de réception (152) définie précédemment,
- pilotage du positionnement du second dispositif de retournement (150) et/ou de chacun des éléments de réception (152) pendant le fonctionnement du dispositif de manipulation de composants (100) de telle manière que l'écart entre la position déterminée et la position définie des éléments de réception (132) soit évité dans toutes les positions de transfert possibles.

11. Procédé selon l'une des revendications précédentes, dans lequel un contrôle de la qualité de détection de l'agencement de capteurs d'ajustement et/ou un contrôle de l'intégrité du dispositif de réception (132) est effectué à l'aide des comparaisons.
